# EUROPEAN PATENT APPLICATION

(11) **EP 4 257 877 A1**
(43) Date of publication of application: **11.10.2023**
(21) Application number: 21900504.8
(22) Date of filing: 26.11.2021
(51) Int. Cl.: F21Y 115/10, F21S 45/40, F21W 102/30, F21W 103/00, F21W 103/35

(54) **LIGHT SOURCE UNIT**

(30) Priority: 04.12.2020 JP 2020202137; 04.12.2020 JP 2020202138; 04.12.2020 JP 2020202139; 04.12.2020 JP 2020202140; 04.12.2020 JP 2020202141
(71) Applicant: KOITO MANUFACTURING CO., LTD., Minato-ku Tokyo 108-8711 (JP)
(72) Inventor: ICHIKAWA, Tomoyuki, Shizuoka-shi, Shizuoka 424-8764 (JP); OZAWA, Atsushi, Shizuoka-shi, Shizuoka 424-8764 (JP); NAKAGAWA, Tomoyuki, Shizuoka-shi, Shizuoka 424-8764 (JP); ITO, Toru, Shizuoka-shi, Shizuoka 424-8764 (JP); SUZUKI, Tetsuya, Shizuoka-shi, Shizuoka 424-8764 (JP)
(74) Representative: Cabinet Beau de Loménie
(86) International application number: PCT/JP2021/043376
(87) International publication number: WO 2022/118750

(57) **Abstract**

The invention includes: a socket housing having an engaging portion that is engaged with a predetermined member; a substrate having a base plate formed by a resin material and a wiring pattern formed in at least a surface on one side, in a thickness direction, of the base plate; a light-emitting element that is connected to the wiring pattern and functions as a light source; an annular frame that is formed on the substrate and covers the light-emitting element from the periphery; a sealing resin that is packed inside the frame and seals the light-emitting element; and an electronic component joined to a land that is formed on an outer circumferential side of the frame as a part of the wiring pattern. The frame is formed as a resin material having fluidity applied to the substrate is hardened. A clearance between the frame and the land or a clearance between the frame and the electronic component, whichever is smaller, is set to be 0.1 mm or larger.

## Description

### TECHNICAL FIELD

The present invention concerns a technical field relating to a light source unit having a socket housing and a substrate disposed in the socket housing and to a vehicle lamp.

### BACKGROUND ART

Examples of vehicle lamps include those in which a light source unit is provided that is attachable to and detachable from a lamp outer casing composed of a lamp body and a cover, and in which a light-emitting element, such as a light-emitting diode, is used as a light source of the light source unit.

Such a light source unit is provided with a light-emitting element that functions as a light source and a substrate in which a wiring pattern for supplying a current to at least the light-emitting element is formed, and the substrate is mounted to and disposed in a socket housing (e.g., see Patent Literature 1).

### Citation List

### Patent Literature

[Patent Literature 1] Japanese Unexamined Patent Application Publication No. 2016-195099

### SUMMARY OF THE INVENTION

Some light source units like the one described above have a configuration in which, as described in Patent Literature 1, an annular frame is disposed around light-emitting elements, and the light-emitting elements, electrically conductive wires connected to the light-emitting elements, etc. are sealed by a sealing resin that is formed by a resin material packed inside the frame, and some such frames are formed as a resin material having fluidity applied to the substrate is hardened. In this configuration, the light-emitting elements, the electrically conductive wires, etc. are protected by being sealed by the sealing resin, so that a stable drive state of the light-emitting elements is secured.

However, since the resin material having fluidity is applied to the substrate when forming the frame, there is a concern that the fluidity of the resin material may cause the resin material to come into contact with electronic components present around the frame or lands to which the electronic components are joined.

When such contact between the resin material and the electronic components etc. occurs, the resin material sticks to the electronic components etc. due to surface tension, so that the shape of the frame formed upon hardening of the resin material may become an inappropriate shape.

When the frame is formed in an inappropriate shape, the sealing resin packed inside the frame leaks from the frame to the outside, so that the height of the sealing resin becomes insufficient. Then, the electronic components and the electrically conductive wires are not entirely sealed by the sealing resin, and the light-emitting elements, the electrically conductive wires, etc. are not sufficiently protected by the sealing resin, which raises a concern that the drive state of the light-emitting elements may become unstable and that an appropriate light distribution state may not be secured.

There are cases where the frame functions as a light reflecting part, and in such cases, any distortion in the shape of the frame may cause the light to be not appropriately reflected or the surface of the sealing resin to be distorted, so that the light may not be appropriately radiated. Further, in some cases, a lens is disposed on the sealing resin, and in such cases, there is a concern that the shape of the lens may be distorted or inclined, resulting in an inappropriate light radiation state.

Furthermore, at a part where the resin material has stuck to the electronic component etc. due to surface tension, the height of the frame becomes smaller than at other parts, so that the height of the resin packed inside the frame becomes partially smaller, thus raising another concern that the state of protection of the light-emitting elements, the electrically conductive wires, etc. by the sealing resin may become an inappropriate state at some parts.

A light source unit of the present invention aims to secure an appropriate light distribution state of light radiated from light-emitting elements by preventing contact between a frame and an electronic component or a connecting part.

First, a light source unit according to the present invention includes: a socket housing having an engaging portion that is engaged with a predetermined member; a substrate having a base plate formed by a resin material and a wiring pattern formed in at least a surface on one side, in a thickness direction, of the base plate; a light-emitting element that is connected to the wiring pattern and functions as a light source; a frame having an annular shape, the frame being formed on the substrate and covering the light-emitting element from a periphery; a sealing resin that is packed inside the frame and seals the light-emitting element; and an electronic component joined to a land that is formed on an outer circumferential side of the frame as a part of the wiring pattern. The frame is formed as a resin material having fluidity applied to the substrate is hardened. A clearance between the frame and the land or a clearance between the frame and the electronic component, whichever is smaller, is set to be 0.1 mm or larger.

Thus, even when the resin material for forming the frame flows, the resin material reaches none of the lands and the electronic components, nor does the resin material stick to the lands and the electronic components due to surface tension.

Second, another light source unit according to the present invention includes: a socket housing having an engaging portion that is engaged with a predetermined member and a heat radiation plate that radiates heat to an outside; a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate; and a light-emitting element that is connected to the wiring pattern and functions as a light source. An element thermal via that has one end and the other end respectively connected to the wiring pattern and the heat radiation pattern and transfers heat to the heat radiation plate is formed in the substrate. When axes passing through the light-emitting element and extending in a thickness direction of the substrate are called reference axes, at least part of the element thermal via is present on one of the reference axes.

Thus, the substrate can be inexpensively formed. Since the light-emitting element and the element thermal via are positioned close to each other, the transfer path of heat resulting from driving the light-emitting element toward the element thermal via is shortened.

Third, in the above-described another light source unit according to the present invention, it is desirable that when one of the reference axes that passes through the center of the light-emitting element is called a central axis, at least part of the element thermal via be present on the central axis.

Thus, the element thermal via is present at a position close to the center of the light-emitting element.

Fourth, in the above-described another light source unit according to the present invention, it is desirable that the element thermal via be entirely positioned in a projected space obtained by projecting the light-emitting element in an axial direction of a reference axis of the reference axes.

Thus, the element thermal via is not present outside the projected space.

Fifth, in the above-described another light source unit according to the present invention, it is desirable that: a package-type light-emitting body be provided in which a plurality of the light-emitting elements is each joined to a die pad and at least the plurality of the light-emitting elements is sealed by a sealing part; a plurality of the element thermal vias be formed in the substrate; and at least part of the element thermal via be present on each of the reference axes of the plurality of the light-emitting elements.

Thus, as the package-type light-emitting body is mounted on the substrate, there is no need to separately mount a plurality of light-emitting elements onto the substrate and an appropriate distance between the plurality of light-emitting elements is secured, as well as the work of mounting the light-emitting elements onto the substrate is made easy.

Sixth, in the above-described another light source unit according to the present invention, it is desirable that a plurality of electronic components be each connected to the wiring pattern by solder, and that a plurality of the die pads be each connected to the wiring pattern by solder.

Thus, the plurality of electronic components and the plurality of light-emitting elements are each connected to the wiring pattern by soldering.

Seventh, in the above-described another light source unit according to the present invention, it is desirable that a resist be applied to the heat radiation pattern, and that the heat radiation pattern be joined to the heat radiation plate through the resist by a heat-conducting adhesive.

Thus, the heat radiation pattern is connected to the heat radiation plate through the resist, and the heat radiation pattern is bonded to the heat radiation plate by the heat-conducting adhesive.

Eighth, yet another light source unit according to the present invention includes: a socket housing having an engaging portion that is engaged with a predetermined member and a heat radiation plate that radiates heat to an outside; a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate; a light-emitting element that is connected to the wiring pattern and functions as a light source; a plurality of electronic components including an integrated circuit and connected to the wiring pattern; and a plurality of connection terminals including a ground terminal and connected to a power source. A circuit thermal via that has one end and the other end respectively connected to the wiring pattern and the heat radiation pattern and transfers heat generated in the integrated circuit to the heat radiation plate is formed in the substrate. The substrate is formed by a plurality of layers including a ground layer and laminated in a thickness direction. A ground pattern is formed in an area of half or more of the ground layer. The circuit thermal via is connected to the ground pattern and the ground pattern is connected to the ground terminal.

Thus, the circuit thermal via that transfers heat generated in the integrated circuit to the heat radiation plate is connected to the ground pattern that is formed in an area of half or more of the ground layer, and the ground pattern is connected to the ground terminal, which enhances performance against electromagnetic noise.

Ninth, in the above-described yet another light source unit according to the present invention, it is desirable that: a heat radiation pad be provided on a bottom surface of the integrated circuit; a plurality of the circuit thermal vias be formed; a circuit connecting part to which the heat radiation pad is connected be formed in the wiring pattern; and the plurality of the circuit thermal vias be connected to the circuit connecting part.

Thus, the plurality of circuit thermal vias is connected to the heat radiation pad of the integrated circuit through the circuit connecting part.

Tenth, in the above-described yet another light source unit according to the present invention, it is desirable that: a package-type light-emitting body be provided in which a plurality of the light-emitting elements is each joined to a die pad and at least the plurality of the light-emitting elements is sealed by a sealing part; a plurality of element thermal vias each of which has one end and the other end respectively connected to the wiring pattern and the heat radiation pattern and transfers heat generated in the light-emitting element to the heat radiation plate be formed in the substrate; and the element thermal vias be connected to the ground pattern and the ground pattern be connected to the ground terminal.

Thus, as the package-type light-emitting body is mounted on the substrate, there is no need to separately mount a plurality of light-emitting elements onto the substrate and an appropriate distance between the plurality of light-emitting elements is secured, as well as the work of mounting the light-emitting elements 61 onto the substrate is made easy.

Eleventh, in the above-described yet another light source unit according to the present invention, it is desirable that a plurality of element connecting parts to which a plurality of the die pads is respectively connected be formed in the wiring pattern, and that the plurality of element thermal vias is connected to the element connecting parts.

Thus, the plurality of element thermal vias is connected through the element connecting parts to the die pads to which the light-emitting elements are joined.

Twelfth, in the above-described yet another light source unit according to the present invention, it is desirable that a resist be applied to the heat radiation pattern, and that the heat radiation pattern be joined to the heat radiation plate through the resist by a heat-conducting adhesive.

Thus, the heat radiation pattern is connected to the heat radiation plate through the resist, and the heat radiation pattern is bonded to the heat radiation plate by the heat-conducting adhesive.

Thirteenth, still another light source unit according to the present invention includes: a socket housing having an engaging portion that is engaged with a predetermined member and a heat radiation plate that radiates heat to an outside; a substrate having a wiring pattern formed in at least a surface on one side in a thickness direction and a heat radiation pattern formed in a surface on the other side in the thickness direction, the heat radiation pattern being connected to the heat radiation plate; a power feeder having a terminal holding part formed by an insulating resin material and a connection terminal held by the terminal holding part, both end portions of the connection terminal protruding from the terminal holding part; and a light-emitting element that is connected to the wiring pattern and functions as a light source. A first connecting part and a second connecting part are formed in the substrate so as to be spaced apart in a thickness direction. A first terminal land is formed on the first connecting part, and a second terminal land is formed on the second connecting part. A terminal through-hole into which a portion of the connection terminal is inserted from the side of the second connecting part is formed in the substrate between the first connecting part and the second connecting part. The size of the second terminal land is set to be smaller than the size of the first terminal land. A portion of the connection terminal is joined to the terminal through-hole, the first terminal land, and the second terminal land by solder.

Thus, the amount of solder applied to the second terminal land becomes smaller than the amount of solder applied to the first terminal land, and the amount of solder flowing through the terminal through-hole toward the terminal holding part is reduced.

Fourteenth, in the above-described still another light source unit according to the present invention, it is desirable that the power feeder have the terminal holding part held in a state of being embedded in the socket housing.

Thus, a portion of the connection terminal is connected to the substrate in the state where the terminal holding part is held by the socket housing.

Fifteenth, in the above-described still another light source unit according to the present invention, it is desirable that the socket housing be provided with a resin-molded part formed by a heat-conducting resin material, and that the terminal holding part be embedded in the resin-molded part.

Thus, heat generated in the light-emitting element and the substrate is released to the outside by the resin-molded part in which the terminal holding part is embedded.

Sixteenth, in the above-described still another light source unit according to the present invention, it is desirable that a package-type light-emitting body be provided in which a plurality of the light-emitting elements is each joined to a die pad and at least a plurality of the heat radiation plates and the plurality of the light-emitting elements are sealed by a sealing resin, and that the light-emitting elements of the light-emitting body be connected to the wiring pattern.

Thus, as the package-type light-emitting body is mounted on the substrate, there is no need to separately mount a plurality of light-emitting elements onto the substrate and an appropriate distance between the plurality of light-emitting elements is secured, as well as the work of mounting the light-emitting elements onto the substrate is made easy.

Seventeenth, a further light source unit according to the present invention includes: a socket housing having an engaging portion that is engaged with a predetermined member and a heat radiation plate that radiates heat to an outside; a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate; a light-emitting element that is connected to the wiring pattern and functions as a light source; and a plurality of electronic components including an integrated circuit and connected to the wiring pattern. A ground part is formed as a part of the wiring pattern between an outer circumference of the substrate and the integrated circuit.

Thus, static electrical charges applied from the outer circumferential side of the substrate are more likely to jump into the ground part formed between the outer circumference of the substrate and the integrated circuit.

Eighteenth, in the above-described further light source unit according to the present invention, it is desirable that the ground part be formed at an outer circumferential part of the substrate.

Thus, the ground part can be formed in a shape conforming to the outer circumference of the substrate, so that the area of formation of the ground part can be increased as well as the ground part can be formed at a position where the integrated circuit is covered from the outer side.

Nineteenth, in the above-described further light source unit according to the present invention, it is desirable that a resistless region to which no resist has been applied be formed in the ground part.

Thus, static electrical charges applied from the outer circumferential side of the substrate are more likely to jump into the ground part from the resistless region, while the portion of the ground part other than the resistless region is protected by the resist.

Twentieth, in the above-described further light source unit according to the present invention, it is desirable that: the substrate be formed by a plurality of layers including a ground layer and laminated in a thickness direction; a ground pattern be formed in an area of half or more of the ground layer; a ground through-hole connected to the ground part be formed in the substrate; and the ground part be connected to the ground pattern through the ground through-hole.

Thus, static electrical charges having jumped into the ground part from the outer circumferential side of the substrate flow through the ground through-hole to the ground pattern having a large area.

According to the present invention, even when the resin material for forming the frame flows, the resin material reaches none of the lands and the electronic components, nor does the resin material stick to the lands and the electronic components due to surface tension. Thus, it is possible to secure an appropriate light distribution state of light radiated from the light-emitting elements by preventing contact between the frame and the electronic components or the connecting parts.

### BRIEF DESCRIPTION OF THE DRAWINGS

[FIG. 1] Showing an embodiment of the present invention along with FIG. 2 through FIG. 25, FIG. 1 is a sectional view of a vehicle lamp.
[FIG. 2] Showing a light source unit according to a first embodiment along with FIG. 3 through FIG. 14, FIG. 2 is an exploded perspective view of the light source unit.
[FIG. 3] FIG. 3 is a perspective view of the light source unit.
[FIG. 4] FIG. 4 is a sectional view of the light source unit.
[FIG. 5] FIG. 5 is a rear view of the light source unit.
[FIG. 6] FIG. 6 is a schematic plan view showing a mounted state of electronic components etc. on a substrate.
[FIG. 7] FIG. 7 is an enlarged sectional view showing a state where a lens is disposed on a sealing resin in which light-emitting elements are sealed.
[FIG. 8] FIG. 8 is a plan view showing part of a first wiring layer etc. in the substrate.
[FIG. 9] FIG. 9 is a plan view showing part of a ground layer in the substrate.
[FIG. 10] FIG. 10 is a plan view showing part of a heat radiation layer in the substrate like a transparent view.
[FIG. 11] FIG. 11 is a sectional view showing a light-emitting element, the substrate, etc.
[FIG. 12] FIG. 12 is a sectional view showing the light-emitting element, the substrate, etc. in a state where a central axis and a centerline do not coincide with each other.
[FIG. 13] FIG. 13 is a sectional view showing a state of connection of a ground part to a ground pattern etc.
[FIG. 14] FIG. 14 is a sectional view showing a state of connection of connection terminals to the substrate etc.
[FIG. 15] Showing a light source unit according to a second embodiment along with FIG. 16 through FIG. 25, FIG. 15 is an exploded perspective view of the light source unit.
[FIG. 16] FIG. 16 is a perspective view of the light source unit.
[FIG. 17] FIG. 17 is a schematic plan view showing a mounted state of the electronic components etc. on the substrate.
[FIG. 18] FIG. 18 is an enlarged sectional view showing the substrate and a light-emitting body.
[FIG. 19] FIG. 19 is a plan view showing part of a first wiring layer etc. in the substrate.
[FIG. 20] FIG. 20 is a plan view showing part of a ground layer in the substrate.
[FIG. 21] FIG. 21 is a plan view showing part of a heat radiation layer in the substrate like a transparent view.
[FIG. 22] FIG. 22 is a sectional view showing a light-emitting element, the substrate, etc.
[FIG. 23] FIG. 23 is a sectional view showing the light-emitting element, the substrate, etc. in a state where a central axis and a centerline coincide with each other.
[FIG. 24] FIG. 24 is a sectional view showing a state of connection of the ground part to a ground pattern etc.
[FIG. 25] FIG. 25 is a sectional view showing a state of connection of connection terminals to the substrate.

### MODES FOR CARRYING OUT THE INVENTION

Modes for carrying out the present invention will be described below with reference to the accompanying drawings.

In the following description, frontward, rearward, upward, downward, leftward, and rightward directions will be indicated based on an optical axis direction being the front-rear direction and a light radiation direction being the frontward direction. The frontward, rearward, upward, downward, leftward, and rightward directions indicated in the following are for the convenience of description, and implementation of the present invention is not limited to those directions.

### Schematic Configuration of Vehicle Lamp

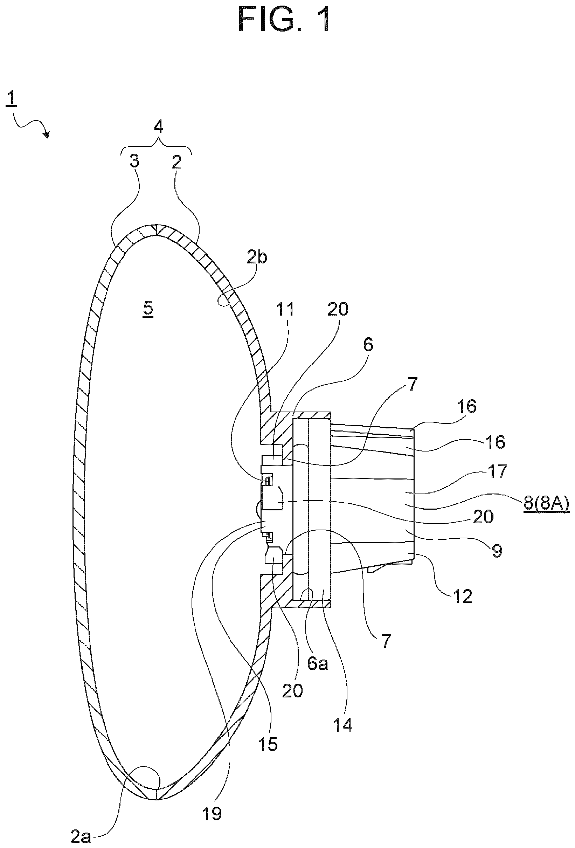

First, a schematic configuration of a vehicle lamp will be described (see FIG. 1).

A vehicle lamp 1 includes a lamp body 2 having a recess that is open frontward, and a cover 3 that closes an opening 2a on a rear side of the lamp body 2. The lamp body 2 and the cover 3 constitute a lamp outer casing 4, and an internal space of the lamp outer casing 4 is formed as a lamp chamber 5.

A rear end part of the lamp body 2 is provided as a unit mounting part 6 that has a substantially cylindrical shape and is bored in the front-rear direction, and a space inside the unit mounting part 6 is formed as a mounting hole 6a. On an inner circumferential surface of the unit mounting part 6, engaging protrusions 7 protruding inward are provided so as to be spaced apart in a circumferential direction. Metal vapor deposition, for example, is applied to an inner surface of the lamp body 2, and this inner surface is formed as a reflective surface 2b.

Other than the lamp outer casing 4 composed of the lamp body 2 and the cover 3, the vehicle lamp 1 includes a light source unit 8 that is attachable to and detachable from the unit mounting part 6 of the lamp body 2. The vehicle lamp 1 may be configured to include, other than the lamp outer casing 4, a light source unit 8A that is attachable to and detachable from the unit mounting part 6.

The light source unit 8 is used in, for example, a combination lamp having the functions of a stop lamp and a tail lamp, and the light source unit 8A is used in, for example, a lamp having the function of a fog lamp. However, the range of application of the present invention is not limited to a light source unit that is used in a combination lamp having the functions of a stop lamp and a tail lamp or in a lamp having the function of a fog lamp, and to a vehicle lamp including this light source unit.

The light source unit of the present invention can be widely applied to light source units used for various types of vehicle lamps that are lamps other than a stop lamp, a tail lamp, and a fog lamp, regardless of whether the lamp is a combination lamp or a single-function lamp. Further, the vehicle lamp of the present invention can be widely applied to vehicle lamps including these various types of light source units.

### Structure of Light Source Unit According to First Embodiment

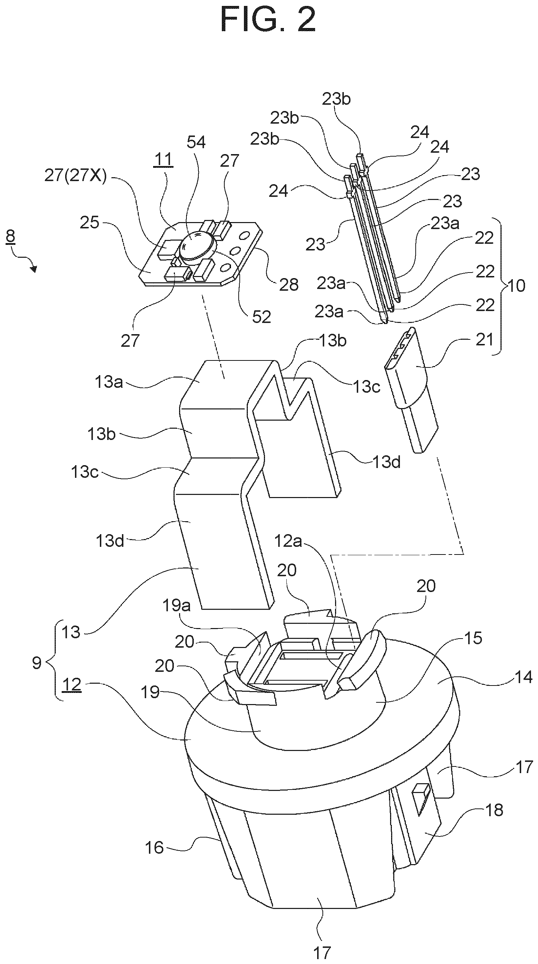

In the following, the structure of a light source unit 8 according to a first embodiment will be described (see FIG. 2 through FIG. 14).

The light source unit 8 has a socket housing 9, a power feeder 10, and a light-emitting module 11 (see FIG. 2 through FIG. 4).

The socket housing 9 is formed as a resin-molded part 12 and a heat radiation plate 13 are integrally molded, for example. As integral molding, for example, so-called insert molding is used in which a molten resin (resin material) is packed into a cavity of a mold with a metal material held therein and a molded article is integrally formed by the metal material and the resin material. In the socket housing 9, the metal material corresponds to the heat radiation plate 13 and the resin material corresponds to the resin-molded part 12.

The resin-molded part 12 is formed by a resin material having excellent heat conductivity and containing carbon, for example, and also has electrical conductivity. The resin-molded part 12 has a disc-shaped base surface part 14 facing the front-rear direction, a protruding part 15 protruding frontward from a center part of the base surface part 14, first heat radiation fins 16 protruding rearward from the base surface part 14, second heat radiation fins 17 protruding rearward from the base surface part 14, and a connector coupling part 18 protruding rearward from the base surface part 14.

The protruding part 15 has a substrate placing portion 19 having a circular outer shape, and engaging portions 20 protruding from an outer circumferential surface of the substrate placing portion 19.

A placing recess 19a that opens frontward is formed in the substrate placing portion 19. The placing recess 19a has a substantially rectangular shape and is slightly larger than an outer shape of the light-emitting module 11. The engaging portions 20 are provided so as to be spaced apart in a circumferential direction. The engaging portions 20 are positioned at a front end portion of the substrate placing portion 19.

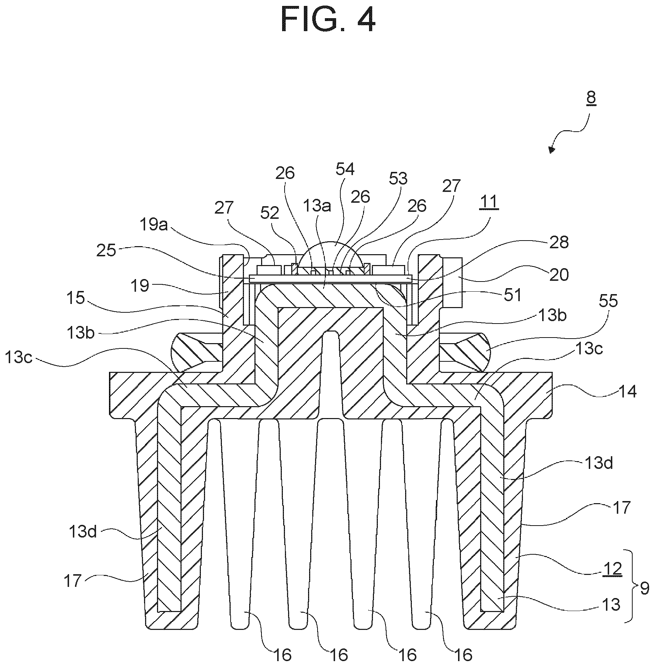

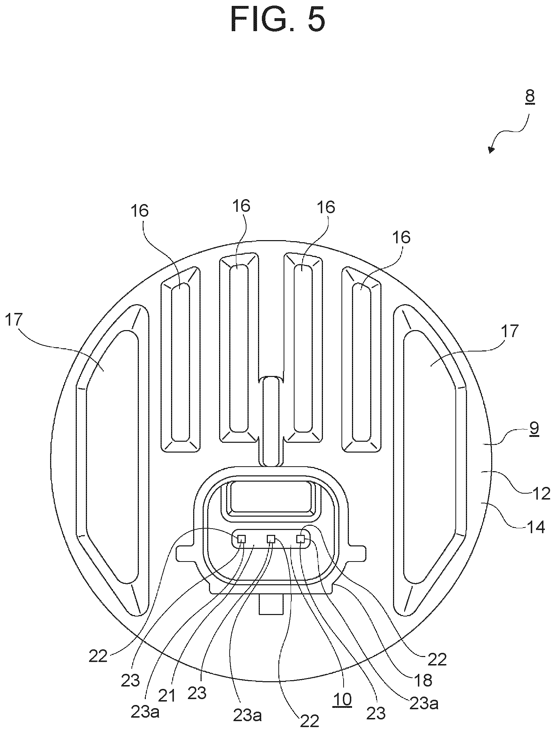

The first heat radiation fins 16 are provided in a row at regular intervals in the left-right direction, for example, and protrude from a portion of the base surface part 14 other than left and right end portions thereof, for example, from an upper half portion (see FIG. 4 and FIG. 5).

The second heat radiation fins 17 are positioned one on each side of the first heat radiation fins 16 in the left-right direction and protrude from the left and right end portions of the base surface part 14. The thickness of the second heat radiation fin 17 in the left-right direction is set to be larger than the thickness of the first heat radiation fin 16 in the left-right direction.

The connector coupling part 18 has a tubular shape with an axial direction oriented in the front-rear direction and is disposed on a lower side of the first heat radiation fins 16.

The heat radiation plate 13 functions as a heatsink, and is formed as a plate-shaped metal material having high heat conductivity, such as aluminum, is formed into a predetermined shape (see FIG. 2 and FIG. 4). The resin-molded part 12 is also formed by a resin material having excellent heat conductivity, and thus functions also as a heatsink along with the heat radiation plate 13.

The heat radiation plate 13 is composed of a first heat radiation part 13a, second heat radiation parts 13b, third heat radiation parts 13c, and fourth heat radiation parts 13d.

Each of the first heat radiation part 13a and the third heat radiation parts 13c has a substantially rectangular shape facing the front-rear direction, and each of the second heat radiation parts 13b and the fourth heat radiation parts 13d has a substantially rectangular shape facing the left-right direction. Front ends of the respective second heat radiation parts 13b continue to left and right ends of the first heat radiation part 13a, and inner ends of the respective third heat radiation parts 13c continue to rear ends of the second heat radiation parts 13b while outer ends thereof continue to front ends of the fourth heat radiation parts 13d. Thus, the second heat radiation parts 13b are each formed by being bent in a direction orthogonal to the first heat radiation part 13a. The third heat radiation parts 13c are each formed by being bent in a direction orthogonal to the second heat radiation part 13b. The fourth heat radiation parts 13d are each formed by being bent in a direction orthogonal to the third heat radiation part 13c.

The heat radiation plate 13 has the first heat radiation part 13a positioned in the placing recess 19a of the substrate placing portion 19 in the resin-molded part 12 and exposed from the resin-molded part 12 (see FIG. 4). The heat radiation plate 13 has the fourth heat radiation parts 13d respectively positioned inside the second heat radiation fins 17, the second heat radiation parts 13b disposed inside the substrate placing portion 19, and the third heat radiation parts 13c positioned inside the base surface part 14.

An inserting-placing hole 12a is formed in the resin-molded part 12 at a position from the substrate placing portion 19 to the base surface part 14, and the inserting-placing hole 12a communicates with the placing recess 19a and an inside of the connector coupling part 18 (see FIG. 2).

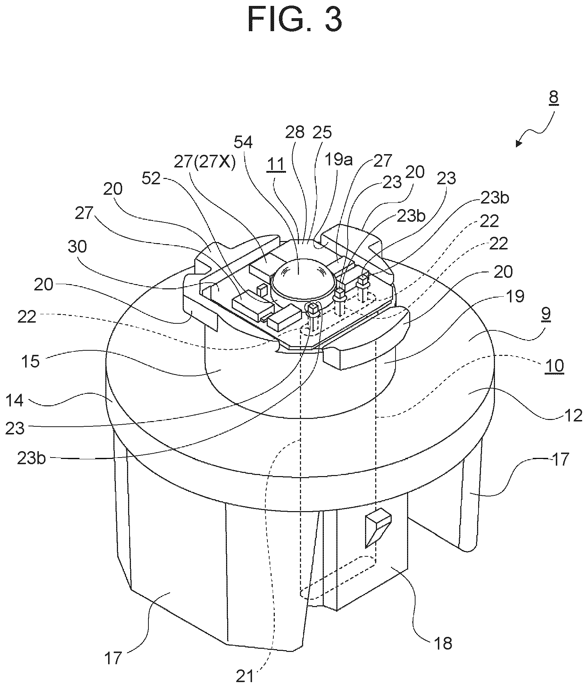

The power feeder 10 has a terminal holding part 21 formed by an insulating resin material, and connection terminals 22 that are held by the terminal holding part 21 and connected to a power source circuit (external power; not shown) (see FIG. 2 and FIG. 3).

The terminal holding part 21 has a flat shape that extends in the front-rear direction and has a small thickness in the up-down direction.

The connection terminals 22 are formed by a metal material and are positioned, except for a portion thereof, inside the terminal holding part 21 in a row in the left-right direction. Each connection terminal 22 is composed of a terminal part 23 extending in the front-rear direction, and fall-prevention protrusions 24 protruding in opposite directions from each other from a position close to a front end of the terminal part 23. A rear end portion of the terminal part 23 is provided as a connector connecting part 23a and a front end portion thereof is provided as a pattern connecting part 23b.

The connection terminal 22 has the connector connecting part 23a protruding rearward from the terminal holding part 21 and the pattern connecting part 23b protruding frontward from the terminal holding part 21. By having the fall-prevention protrusions 24 positioned inside the terminal holding part 21, the connection terminal 22 is prevented from falling off the terminal holding part 21 in the front-rear direction.

Of the connection terminals 22, one is provided as a ground terminal 22G for grounding and the other two are provided for power supply. Of the connection terminals 22 for power supply, one is for a stop lamp and the other is for a tail lamp.

In the power feeder 10, the terminal holding part 21 and the connection terminals 22 are integrally formed by, for example, insert molding. Of the power feeder 10, parts other than the connector connecting parts 23a and the pattern connecting parts 23b are inserted into the inserting-placing hole 12a formed in the resin-molded part 12, while the connector connecting parts 23a are positioned inside the connector coupling part 18 (see FIG. 5) and the pattern connecting parts 23b are positioned in the placing recess 19a (see FIG. 3).

The power feeder 10 is disposed in a cavity of a mold in a state of having being formed by insert molding, for example, and a molten resin for forming the resin-molded part 12 is packed into the cavity, and the power feeder 10 is integrally formed with the socket housing 9 by, for example, insert molding.

The light-emitting module 11 has a substrate 25 that has a substantially rectangular shape and faces the front-rear direction, light-emitting elements 26 mounted on the substrate 25, and various electronic components 27 mounted on the substrate 25 (see FIG. 2, FIG. 3, and FIG. 6).

For example, five light-emitting elements 26 are mounted at a center part of the substrate 25, and light-emitting diodes (LEDs) are used as the light-emitting elements 26. The light-emitting elements 26 are mounted in a state where four light-emitting elements 26 are spaced apart at regular intervals in the circumferential direction around one light-emitting element 26, and the center light-emitting element 26 functions as a light source for a tail lamp, for example, while the surrounding four light-emitting elements 26 function as light sources for a stop lamp, for example.

The number and functions of the light-emitting elements 26 mounted on the substrate 25 can be set arbitrarily according to the type of the vehicle lamp 1, the required luminance, etc.

As the electronic components 27, for example, other than an integrated circuit (IC) 27X, a diode, a capacitor, a resistor, etc. are used, and the electronic components 27 are mounted on the substrate 25 at positions on an outer side of the light-emitting elements 26. Other than the integrated circuit 27X etc., the electronic components 27 may also be a metal-oxide-semiconductor field-effect transistor (MOSFET) and the like.

The substrate 25 is configured with a wiring pattern, a heat radiation pattern, etc., to be described later, formed on a base plate 28 that is formed by a resin material, such as glass epoxy, and terminal insertion holes 25a are formed at a lower end part of the substrate 25 so as to be spaced apart in the left-right direction.

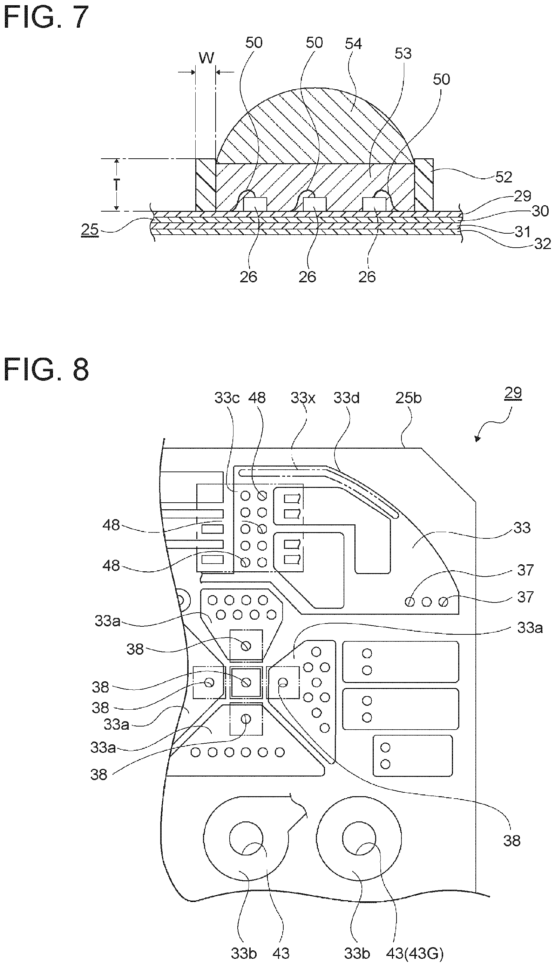

For example, the substrate 25 is formed by the four layers of a first wiring layer 29, a ground layer 30, a second wiring layer 31, and a heat radiation layer 32 that are laminated in this order from the front side in a thickness direction (see FIG. 7).

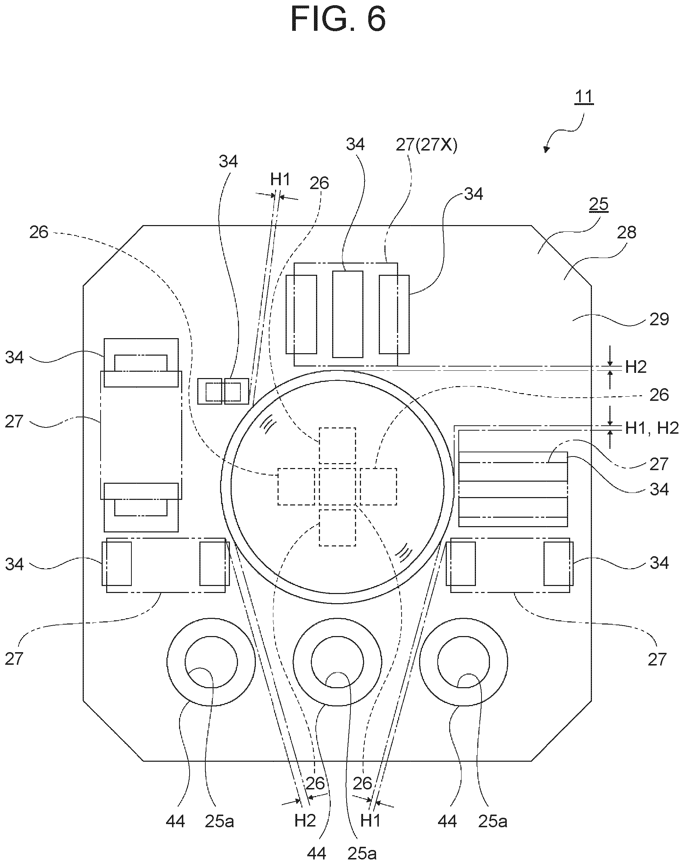

A wiring pattern 33 is formed in a front surface of the first wiring layer 29 (see FIG. 8). Lands 34 to which the electronic components 27 etc. are joined by solder are formed at predetermined positions in the wiring pattern 33 (see FIG. 6). An insulating resist (not shown) for protecting the wiring pattern 33 is applied to a part of the front surface of the first wiring layer 29 where the lands 34 are not formed.

The wiring pattern 33 has element connecting parts 33a to which the light-emitting elements 26 are respectively connected, first connecting parts 33b to which the connection terminals 22 are respectively connected, and a circuit connecting part 33c to which the integrated circuit 27X is connected (see FIG. 8). The element connecting parts 33a are formed at a center part of the substrate 25, and the first connecting parts 33b and the circuit connecting part 33c are formed substantially on opposite sides from each other across the element connecting parts 33a.

A ground part 33d is formed in the wiring pattern 33 at a part continuing to the circuit connecting part 33c. The ground part 33d is formed at an outer circumferential part of the substrate 25 and positioned between an outer circumference 25b of the substrate 25 and the integrated circuit 27X mounted on the circuit connecting part 33c. The ground part 33d has a shape extending in the circumferential direction along the outer circumference 25b of the substrate 25. As long as the ground part 33d is positioned between the outer circumference 25b of the substrate 25 and the integrated circuit 27X, the ground part 33d need not be formed so as to continue to the circuit connecting part 33c.

While a resist for protecting the wiring pattern 33 is applied to a predetermined part of the front surface of the first wiring layer 29, a resistless region 33x to which no resist has been applied is formed at a portion of the ground part 33d. The resistless region 33x has a substantially arc shape so as to conform to the outer circumference 25b of the substrate 25 according to the shape of the ground part 33d.

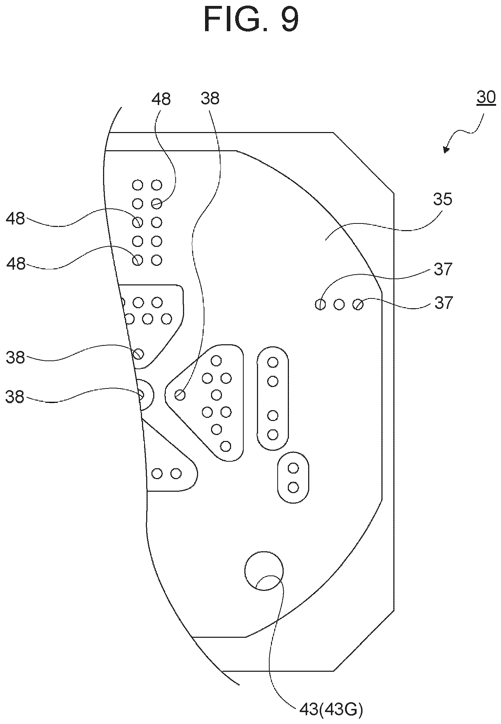

A ground pattern 35 is formed in a front surface or a rear surface of the ground layer 30 (see FIG. 9). The ground pattern 35 is formed in an area of half or more of the front surface or the rear surface of the ground layer 30, and the ground pattern 35 is a part that is a so-called solid ground.

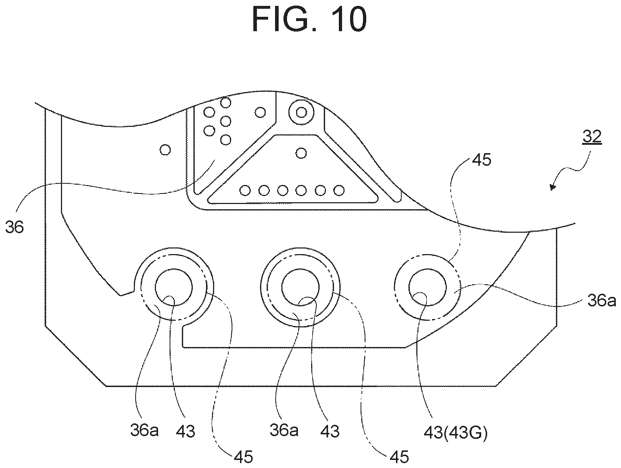

A wiring pattern (not shown) is formed in a front surface or a rear surface of the second wiring layer 31, and a heat radiation pattern 36 is formed in a rear surface of the heat radiation layer 32 (see FIG. 10). In FIG. 10, the heat radiation pattern 36 etc. are shown in a transparent view in a state as seen from the front side. Second connecting parts 36a to which the connection terminals 22 are respectively connected are formed in the rear surface of the heat radiation layer 32.

The ground part 33d of the wiring pattern 33 is connected to the ground pattern 35 of the ground layer 30 through ground through-holes 37 (see FIG. 8 and FIG. 9).

As will be described later, the light source unit 8 is mounted to the lamp body 2 as the engaging portions 20 of the socket housing 9 are engaged with the engaging protrusions 7 of the lamp outer casing 4. In some cases, the light source unit 8 is mounted to a reflector (not shown).

The light source unit as described above is used by being mounted to, for example, a lamp body, a reflector, etc. having a reflective surface. A vehicle lamp is formed as the light source unit is mounted to a lamp body, a reflector, etc. In the vehicle lamp, light radiated from the light-emitting elements of the light source unit is reflected by the reflector formed in the lamp body, the reflector, etc., transmitted through the cover mounted on the lamp body, and emitted toward the outside.

Thus, the light source unit is used by being mounted to a lamp body, a reflector, etc. having a reflective surface, and the reflective surface is formed by performing metal vapor deposition. In the lamp body, the reflector, etc., there is sometimes a part that is formed by metal other than the part of the reflective surface.

Therefore, this part formed by metal in the lamp body, the reflector, etc. may be electrostatically charged.

Since the lamp body, the reflector, etc. may be thus electrostatically charged, when the light source unit is mounted to the lamp body, the reflector, etc., the static electrical charges carried by the lamp body, the reflector, etc. present on the outer circumferential side of the light source unit may jump into the light source unit.

The light source unit is provided with the substrate on which the light emitting elements that radiate light and various electronic components, including the integrated circuit, are mounted. Therefore, when static electrical charges jump into the electronic components, particularly the integrated circuit, the drive state of the circuit (lighting circuit) formed in the substrate may become unstable, or deterioration or breakage of the electronic components and the light-emitting elements may occur, leading to abnormal lighting or failure to light.

To prevent static electrical charges from thus jumping into the substrate, it is conceivable to adopt a configuration in which the part such as the lamp body or the reflector is connected to the ground, but adopting this configuration would increase the cost.

As described above, the light source unit 8 is mounted to the lamp body 2 or the reflector, and the lamp body 2 and the reflector have a part where metal vapor deposition has been performed, for example, the reflective surface 2b. Static electrical charges may jump into the integrated circuit 27X from the lamp body 2 or the reflector present on the outer circumferential side of the light source unit 8, thereby disrupting the appropriate drive state of the circuit (lighting circuit) formed in the substrate 25. In this case, to prevent static electrical charges from jumping in, it is conceivable to adopt a configuration in which the lamp body 2 or the reflector is connected to the ground, but adopting this configuration would increase the cost.

Therefore, as described above, the ground part 33d is formed as a part of the wiring pattern 33 in the light source unit 8, between the outer circumference 25b of the substrate 25 and the integrated circuit 27X. As the ground part 33d is formed, static electrical charges applied from the outer circumferential side of the substrate 25 are more likely to jump into the ground part 33d formed between the outer circumference 25b of the substrate 25 and the integrated circuit 27X, so that an appropriate drive state of the circuit formed in the substrate 25 can be secured without an increase in the manufacturing cost.

Since the ground part 33d is formed at an outer circumferential part of the substrate 25, the ground part 33d can be formed in a shape conforming to the outer circumference 25b of the substrate 25. Thus, the area of formation of the ground part 33d can be increased, as well as the ground part 33d can be formed at a position where the integrated circuit 27X is covered from the outer side, which can effectively prevent static electrical charges from jumping into the integrated circuit 27X.

Further, the resistless region 33x to which no resist has been applied is formed in the ground part 33d.

Thus, static electrical charges applied from the outer circumferential side of the substrate 25 are more likely to jump into the ground part 33d from the resistless region 33x, while the other portion of the ground part 33d than the resistless region 33x is protected by the resist, so that static electrical charges can be prevented from jumping into the integrated circuit 27X while the ground part 33d is protected.

Furthermore, the ground through-holes 37 that are connected to the ground part 33d are formed in the substrate 25, and the ground part 33d is connected to the ground pattern 35 through the ground through-holes 37.

Thus, static electrical charges having jumped into the ground part 33d from the outer circumferential side of the substrate 25 flow through the ground through-holes 37 to the ground pattern 35 having a large area, so that static electrical charges can be more reliably prevented from jumping into the integrated circuit 27X.

While the example of preventing static electrical charges from jumping into the integrated circuit 27X has been shown above, the target for which static electrical charges are prevented from jumping in is not limited to the integrated circuit 27X, and the target may be other electronic components 27, such as a MOSFET, a diode, a capacitor, or a resistor, or may be the light-emitting elements electrically connected to a pattern in the periphery.

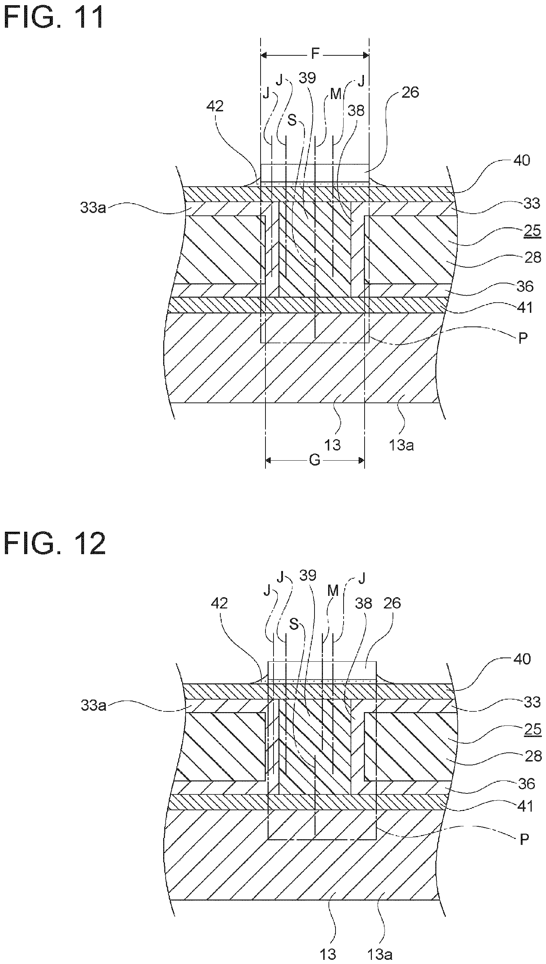

Element thermal vias 38 that are connected to the element connecting parts 33a are formed in the substrate 25 (see FIG. 8). Each element thermal via 38 has one end connected to the element connecting part 33a and the other end connected to the heat radiation pattern 36 (see FIG. 11). One or more element thermal vias 38 are formed for one element connecting part 33a, and one element thermal via 38 is positioned directly behind the light-emitting element 26. That is, a central axis M passing through the center of the light-emitting element 26 and extending in the thickness direction of the substrate 25 and a centerline S of the element thermal via 38 coincide with each other.

In the light source unit 8, heat resulting from driving the light-emitting elements 26 is transferred from the heat radiation pattern 36 to the heat radiation plate 13 through the wiring pattern 33 and the element thermal vias 38, and the element thermal vias 38 are positioned directly behind the light-emitting elements 26. Accordingly, the transfer path of the heat generated in the light-emitting elements 26 to the heat radiation pattern 36 is shortened and the resistance to heat conduction is reduced, so that high heat conductivity of the heat generated in the light-emitting elements 26 to the heat radiation plate 13 is secured.

In the light source unit 8, at least part of the element thermal via 38 should be present on one of axes parallel to the central axis M of the light-emitting element 26, i.e., reference axes J passing through the light-emitting element 26 and extending in the thickness direction of the substrate 25. The centerline S of the element thermal via 38 may be offset from the central axis M of the light-emitting element 26 in a direction orthogonal to the thickness direction of the substrate 25 (see FIG. 12).

Thus, in the light source unit 8, at least part of the range of the element thermal via 38 indicated by G in FIG. 11 should be present in the range of the light-emitting element 26 indicated by F in FIG. 11.

In the light source unit 8, at least part of the element thermal via 38 may be present on the central axis M of the light-emitting element 26.

In the light source unit 8, it is desirable that the element thermal via 38 be entirely or substantially entirely positioned in a projected space P formed by projecting the light-emitting element 26 in an axial direction of the reference axis J (see FIG. 11 and FIG. 12).

A resin (resin ink) 39 may be packed inside of the element thermal via 38. Metal particles may be dispersed in the resin 39, and in this case, the resin 39 has high heat conductivity. In the case where the resin 39 is packed inside the element thermal via 38, a metal coating (cover plating) 40 is applied onto the element connecting part 33a and a metal coating (cover plating) 41 is also applied onto the heat radiation pattern 36. The metal coating 40 may be formed as a land 34, and the metal coating 41 may be formed as a thermal land.

The light-emitting element 26 is mounted on the first wiring layer 29 of the substrate 25 by, for example, a heat-conducting adhesive 42, and as the metal coating 40 is present, the light-emitting element 26 is joined to the metal coating 40 at the element connecting part 33a. Thus, the light-emitting element 26 is joined to the metal coating 40, and not to the resin 39, by the adhesive 42, and the light-emitting element 26 is bonded to the metal (metal coating 40) by the adhesive 42, so that a high degree of bonding of the light-emitting element 26 to the substrate 25 can be secured.

In the substrate 25, the light-emitting elements 26 are mounted on the wiring pattern 33 and the heat radiation pattern 36 is bonded to the first heat radiation part 13a of the heat radiation plate 13 by a heat-conducting adhesive to be described later. As the metal coating 40 and the metal coating 41 are applied, the resin 39 can be prevented from leaking out of the element thermal vias 38, as well as a high degree of connection of the light-emitting elements 26 to the wiring pattern 33 and a high degree of connection of the substrate 25 to the heat radiation plate 13 can be secured.

A resist (not shown) is applied to a part of the heat radiation pattern 36 to which the other ends of the element thermal vias 38 are connected, and the heat radiation pattern 36 is joined to the heat radiation plate 13 through the resist. Specifically, the resist is applied on the metal coating 41.

Thus, the heat radiation pattern 36 is connected to the heat radiation plate 13 through the resist and the heat radiation pattern 36 is connected to the heat radiation plate 13 by the heat-conducting adhesive, so that favorable insulation between the heat radiation pattern 36 and the heat radiation plate 13 can be secured, as well as favorable heat conductivity from the light-emitting elements 26 to the heat radiation plate 13 through the heat radiation pattern 36 can be secured.

As described above, in the light source unit 8, the element thermal vias 38 each of which has one end and the other end respectively connected to the wiring pattern 33 and the heat radiation pattern 36 and transfers heat to the heat radiation plate 13 are formed in the substrate 25 of which the base plate 28 is formed by a resin material, and at least part of each element thermal via 38 is present on one of the reference axes J.

Thus, as the base plate 28 is formed by a resin material, the substrate 25 can be inexpensively formed. Since the light-emitting elements 26 and the element thermal vias 38 are positioned close to each other and the transfer path of heat resulting from driving the light-emitting elements 26 toward the element thermal vias 38 is shortened, so that a high degree of heat radiation can be secured while the manufacturing cost is reduced.

As a result, the drive state of the light-emitting elements 26 does not become unstable due to heat resulting from driving the light-emitting elements 26, and a favorable luminous state of the light-emitting elements 26 can be secured.

The light source unit 8 can also have a configuration in which at least part of the element thermal via 38 is present on the central axis M.

In this case, the element thermal via 38 is present at a position closer to the center of the light-emitting element 26, so that the transfer path of heat resulting from driving the light-emitting element 26 toward the element thermal via 38 is further shortened and the degree of heat radiation can be further increased.

In particular, when a configuration in which the central axis M of the light-emitting element 26 and the centerline S of the element thermal via 38 coincide with each other is adopted, the center of the element thermal via 38 is present at a position closer to the center of the light-emitting element 26. Thus, the transfer path of heat resulting from driving the light-emitting element 26 toward the element thermal via 38 is even further shortened and the degree of heat radiation can be even further increased.

When the element thermal via 38 is entirely positioned in the projected space P formed by projecting the light-emitting element 26 in the axial direction of the reference axis J, the element thermal via 38 is not present on the outer side of the projected space P. Thus, the transfer path of heat resulting from driving the light-emitting element 26 toward the element thermal via 38 is shortened and the degree of heat radiation can be further increased.

Terminal through-holes 43 that are respectively connected to the first connecting parts 33b are formed in the substrate 25 (see FIG. 8, FIG. 13, and FIG. 14). Each terminal through-hole 43 has one end connected to the first connecting part 33b and the other end connected to the second connecting part 36a.

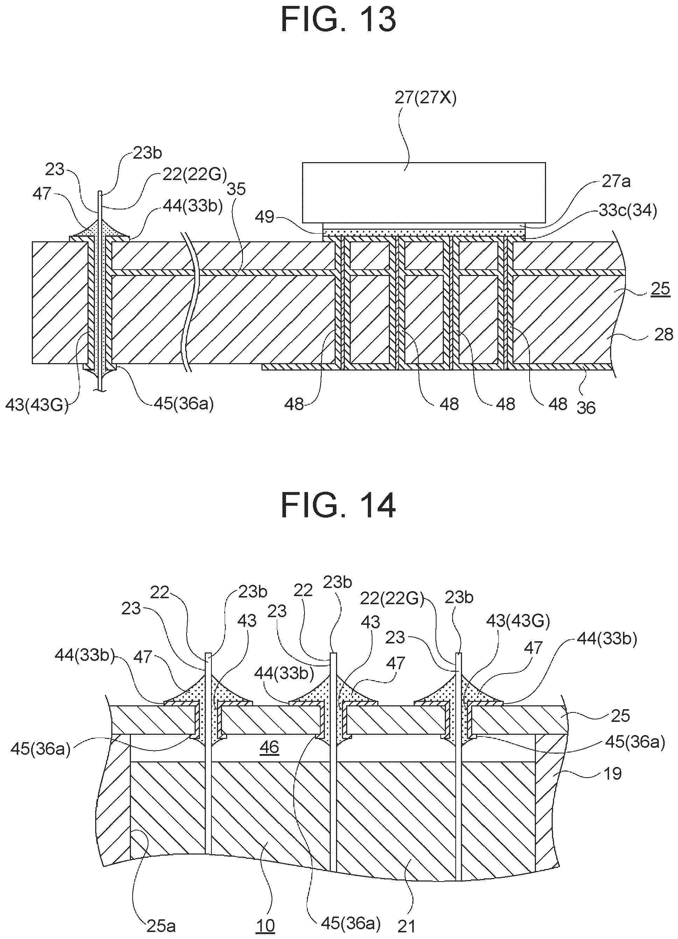

In the first wiring layer 29 of the substrate 25, first terminal lands 44 of an annular shape, for example, are formed on the first connecting parts 33b (see FIG. 6, FIG. 13, and FIG. 14). In the heat radiation layer 32 of the substrate 25, second terminal lands 45 of an annular shape, for example, are formed on the second connecting parts 36a (see FIG. 10 and FIG. 14). The outer shape of the second terminal land 45 is set to be smaller than the outer shape of the first terminal land 44.

The connection terminals 22 of the power feeder 10 are respectively inserted into the terminal through-holes 43 from the side of the second connecting parts 36a, and the connection terminals 22 are connected to the substrate 25 by being joined to the first terminal lands 44, the terminal through-holes 43, and the second terminal land 45. In a state where the connection terminals 22 are connected to the substrate 25, the terminal holding part 21 is held by the socket housing 9 in a state of being inserted in the inserting-placing hole 12a, and the substrate 25 and the terminal holding part 21 are spaced apart from each other in the front-rear direction such that a space 46 is formed therebetween (FIG. 14). In the space 46, the second terminal lands 45 are positioned.

Of the terminal through-holes 43, the through-hole into which the ground terminal 22G is passed is formed as a ground terminal through-hole 43G, and the ground pattern 35 formed in the ground layer 30 is connected to the ground terminal through-hole 43G (see FIG. 13).

The connection terminal 22 is connected to the substrate 25 as the connection terminal 22 is soldered to the first terminal land 44 in a state where the connection terminal 22 is inserted in the terminal through-hole 43 and a portion of the pattern connecting part 23b protrudes frontward from the terminal through-hole 43.

Here, the solder 47 is brought into close contact with the first terminal land 44 and packed into the terminal through-hole 43 due to its fluidity, with part of the solder 47 flowing through the terminal through-hole 43 toward the terminal holding part 21 and brought into close contact with also the second terminal land 45 due to surface tension. Thus, the solder 47 flows around the connection terminal 22 from the first terminal land 44 to the second terminal land 45 through the terminal through-hole 43, and the connection terminal 22 is connected to the substrate 25 by the solder 47.

In this way, the solder 47 flows from the first terminal land 44 through to the second terminal land 45. As described above, since the outer shape of the second terminal land 45 is set to be smaller than the outer shape of the first terminal land 44, the amount of solder 47 for the second terminal land 45 becomes smaller than the amount of solder 47 for the first terminal land 44. Accordingly, the solder 47 is less likely to flow to the terminal holding part 21 of the power feeder 10, as well as is less likely to flow also toward the second terminal lands 45 where the adjacent connection terminals 22 are joined.

As described above, in the light source unit 8, the terminal through-hole 43 into which a portion of the connection terminal 22 is inserted from the side of the second connecting part 36a is formed in the substrate 25, between the first connecting parts 33b and the second connecting parts 36a. The size of the second terminal land 45 is set to be smaller than the size of the first terminal land 44, and a portion of the connection terminal 22 is joined to the terminal through-hole 43, the first terminal land 44, and the second terminal land 45 by the solder 47.

Thus, as the amount of solder 47 applied to the second terminal land 45 becomes smaller than the amount of solder 47 applied to the first terminal land 44, and the amount of solder 47 flowing through the terminal through-hole 43 toward the terminal holding part 21 is reduced, the solder 47 can be prevented from reaching the terminal holding part 21 and favorable functionality of the power feeder 10 can be secured.

In particular, the terminal holding part 21 formed by an insulating resin material can be prevented from being melted by the solder 47, and a decrease in strength of the power feeder 10 and falling of the connection terminal 22 off the terminal holding part 21 can be prevented.

Since the amount of the solder 47 flowing through the terminal through-hole 43 toward the terminal holding part 21 is reduced, the solder 47 is also less likely to flow toward the second terminal lands 45 where the adjacent connection terminals 22 are joined, so that insulation between the connection terminals 22 can be secured to prevent short-circuit.

Further, the power feeder 10 has the terminal holding part 21 held in the state of being embedded in the socket housing 9.

Thus, a portion of the connection terminal 22 is connected to the substrate 25 in the state where the terminal holding part 21 is held by the socket housing 9, so that a stable state of connection of the power feeder 10 to the substrate 25 is secured, and a favorable state of current application to the light-emitting elements 26 through the connection terminal 22 and the wiring pattern 33 can be secured.

Furthermore, the socket housing 9 is provided with the resin-molded part 12 that is formed by a heat-conducting resin material, and the terminal holding part 21 is embedded in the resin-molded part 12.

Thus, heat generated in the light-emitting elements 26 and the substrate 25 is released to the outside by the resin-molded part 12 in which the terminal holding part 21 is embedded, so that high functionality of the socket housing 9 can be secured.

In the substrate 25, the circuit thermal vias 48 that are connected to the circuit connecting part 33c are formed in rows in the up-down and left-right directions, for example (see FIG. 8). Each circuit thermal via 48 has one end connected to the circuit connecting part 33c and the other end connected to the heat radiation pattern 36 (see FIG. 13).

At the circuit connecting part 33c, the integrated circuit 27X is connected onto the circuit thermal vias 48. A heat radiation pad 27a is provided on a bottom surface of the integrated circuit 27X (see FIG. 13). The integrated circuit 27X has the heat radiation pad 27a connected to the circuit connecting part 33c by solder 49.

In the light source unit 8, heat resulting from driving the integrated circuit 27X is transferred from the heat radiation pattern 36 to the heat radiation plate 13 through the wiring pattern 33 and the circuit thermal vias 48. Since the circuit thermal vias 48 are positioned directly behind the integrated circuit 27X, the transfer path of the heat generated in the integrated circuit 27X to the heat radiation pattern 36 is shortened and the resistance to heat conduction is reduced, so that high heat conductivity of the heat generated in the integrated circuit 27X to the heat radiation plate 13 is secured.

Also in the circuit thermal via 48, as in the case of the element thermal via 38, a resin (resin ink) may be packed inside and metal particles may be dispersed in the resin. A metal coating (cover plating) may be applied onto each of the circuit connecting part 33c and the heat radiation pattern 36.

The circuit thermal vias 48 are connected to the ground pattern 35 that is formed in an area of half or more of the ground layer 30. As described above, the ground pattern 35 is connected to the ground terminal through-hole 43G among the terminal through-holes 43 into which the ground terminal 22G is inserted. Thus, the circuit thermal vias 48 are connected to the ground terminal 22G through the ground pattern 35 and the ground terminal through-hole 43G.

A resist (not shown) is applied to a part of the heat radiation pattern 36 to which the other ends of the circuit thermal vias 48 are connected, and the heat radiation pattern 36 is joined to the heat radiation plate 13 through the resist by a heat-conducting adhesive.

Thus, the heat radiation pattern 36 is connected to the heat radiation plate 13 through the resist, and the heat radiation pattern 36 is bonded to the heat radiation plate 13 by a heat-conducting adhesive, so that favorable insulation between the heat radiation pattern 36 and the heat radiation plate 13 can be secured, as well as favorable heat conductivity from the integrated circuit 27X to the heat radiation plate 13 through the heat radiation pattern 36 can be secured.

As described above, in the light source unit 8, the substrate 25 of which the base plate 28 is formed by a resin material is composed of the plurality of layers including the ground layer 30 and laminated in the thickness direction. The ground pattern 35 is formed in an area of half or more of the ground layer 30, and the circuit thermal vias 48 are connected to the ground pattern 35 and the ground pattern 35 is connected to the ground terminal 22G.

Thus, the circuit thermal vias 48 that transfer heat generated in the integrated circuit 27X to the heat radiation plate 13 are connected to the ground pattern 35 formed in an area of half or more of the ground layer 30, and the ground pattern 35 is connected to the ground terminal 22G. Accordingly, as the base plate 28 is formed by a resin material, the substrate 25 can be inexpensively formed, so that a high degree of heat radiation of the heat generated in the integrated circuit 27X can be secured while the manufacturing cost is reduced. In addition, the ground potential of the substrate 25 becomes a low impedance and the influence of static electrical charges on the integrated circuit 27X can be prevented to secure an appropriate drive state of the circuit formed in the substrate 25.

In particular, the lighting circuit of the light-emitting elements 26 used in the vehicle lamp 1 incorporates a linear-regulator constant-current circuit in consideration of a cost reduction etc. As a large amount of electricity is consumed in the linear regulator formed in the integrated circuit 27X, the amount of heat generated in the integrated circuit 27X is likely to increase. However, also when a linear-regulator constant-current circuit is incorporated, the above-described configuration can secure both efficient heat radiation and an appropriate drive state of the lighting circuit.

The heat radiation pad 27a is provided on the bottom surface of the integrated circuit 27X, and the plurality of circuit thermal vias 48 is formed. The circuit connecting part 33c to which the heat radiation pad 27a is connected is formed in the wiring pattern 33, and the plurality of circuit thermal vias 48 is connected to the circuit connecting part 33c.

Thus, as the plurality of circuit thermal vias 48 is connected to the heat radiation pad 27a of the integrated circuit 27X through the circuit connecting part 33c, the degree of heat radiation of the heat generated in the integrated circuit 27X can be further increased.

While the example of increasing the degree of heat radiation of heat generated in the integrated circuit 27X has been shown above, the target for which the degree of heat radiation is increased is not limited to the integrated circuit 27X, and the target may be another electronic component 27, such as a MOSFET, a diode, a capacitor, or a resistor.

The light-emitting elements 26 are respectively connected to the element connecting parts 33a of the wiring pattern 33 through electrically conductive wires 50 that each function as an electrically conductive part (see FIG. 7). The light-emitting elements 26 and the element connecting parts 33a may be connected to each other through other electrically conductive parts than the electrically conductive wires 50, and, for example, may be connected to each other by flip-chip solder-mounting that uses solder as an electrically conductive part.

The substrate 25 has a rear surface bonded to a surface of the first heat radiation part 13a of the heat radiation plate 13 by an adhesive 51 having high heat conductivity (see FIG. 4).

A frame 52 is formed in the substrate 25 between the light-emitting elements 26 and the electronic components 27 (see FIG. 3, FIG. 4, and FIG. 7). The frame 52 is formed in a substantially annular shape by a resin material, for example, and disposed at a position surrounding the light-emitting elements 26 and the electrically conductive wires 50.

The frame 52 is formed as a resin material having fluidity is applied to the substrate 25 in an annular shape and this resin material having fluidity is solidified. As the resin material having fluidity, for example, a silicone material is used.

A sealing resin 53 is packed inside the frame 52, and the light-emitting elements 26 and the electrically conductive wires 50 are sealed by the sealing resin 53 (see FIG. 7). The sealing resin 53 is formed as a liquid resin material is poured into the frame 52 and hardened, and seals the light-emitting elements 26 and the electrically conductive wires 50. Thus, the frame 52 functions to prevent the liquid resin material from flowing unnecessarily toward the electronic components 27 and to give the sealing resin 53 a predetermined shape.

The refractive index of the sealing resin 53 is set to be medium between the refractive index of the light-emitting elements 26 and the refractive index of air, and as the sealing resin 53 seals the light-emitting elements 26, the difference between the refractive index of the light-emitting elements 26 and the refractive index of air is reduced, and the radiation efficiency of light from the light-emitting elements 26 to the outside is increased.

The height of the frame 52 is set to be equal to or larger than the height of the electrically conductive wires 50 connected to the light-emitting elements 26. As the height of the frame 52 is set to be equal to or larger than the height of the electrically conductive wires 50, the sealing resin 53 can be packed inside the frame 52 up to a position equal to or higher than the height of the electrically conductive wires 50, so that the light-emitting elements 26 and the electrically conductive wires 50 disposed inside the frame 52 can be reliably sealed by the sealing resin 53.

Since the frame 52 is formed as a resin material having fluidity is solidified, forming the frame 52 on the substrate 25 does not require the work of mounting the frame to the substrate 25 by an adhesive as in the case of using a frame that is formed as a molded article beforehand. Thus, the work of forming the frame 52 is made easy, as well as the need for an adhesive can be eliminated to reduce the manufacturing cost.

A lens 54 is disposed on the sealing resin 53 in a state of being joined thereto. The lens 54 is formed in a semispherical shape that is convex frontward by a predetermined molding resin. For example, the lens 54 is formed as a predetermined liquid molding resin is packed inside the frame 52 on the unhardened or hardened sealing resin 53 and hardened.

The light source unit 8 may have a configuration in which the lens 54 is not provided. In this case, it is also possible to adopt a configuration in which, for example, the shape of a front end side of the sealing resin 53 has a concave or convex shape such that a part of the sealing resin 53 functions as a lens.

As described above, in the light source unit 8, the lens 54 covering the light-emitting elements 26 etc. is joined to the sealing resin 53, so that light radiated from the light-emitting elements 26 is emitted toward the outside while being controlled by the lens 54. Thus, higher luminous efficiency can be achieved and a desired light distribution pattern can be formed, as well as flexibility in light distribution can be increased.

As described above, in the light source unit 8, the frame 52 surrounding the light-emitting elements 26 and the electrically conductive wires 50 is formed on the substrate 25, with the sealing resin 53 packed inside the frame 52, and a molding resin is applied onto the sealing resin 53 and hardened to form the lens 54.

Thus, the light-emitting elements 26 and the electrically conductive wires 50 are sealed by the sealing resin 53, and the light-emitting elements 26 are covered by the lens 54 molded with high accuracy. As a result, a favorable mounted state of the light-emitting elements 26 on the substrate 25 can be secured, as well as a favorable radiation state of light radiated from the light-emitting elements 26 toward the outside can be secured.

In the following, an outline of the manufacturing process of the light-emitting module 11 will be described.

First, in a soldering step, a solder paste is applied by printing to the lands 34 formed on the substrate 25, and the electronic components 27 are respectively mounted on the solder. The electronic components 27 are joined to the lands 34 by reflow.

Next, in an element mounting step, an adhesive is applied to the position of each element connecting part 33a in the wiring pattern 33, and the light-emitting elements 26 are respectively mounted on the applied adhesive. The adhesive is hardened to respectively connect the light-emitting elements 26 to the element connecting parts 33a, and the electrically conductive wires 50 are respectively connected to the element connecting parts 33a by wire bonding.

Next, in an element sealing step, as described above, the frame 52 is formed and the sealing resin 53 is packed inside the frame 52, and the lens 54 is joined and disposed onto the sealing resin 53.

In this way, the light-emitting module 11 is manufactured as the soldering step, the element mounting step, and the element sealing step are sequentially performed. While it is also possible to manufacture the light-emitting module 11 by performing the soldering step and the element mounting step in reverse order, in this case solder needs to be applied by dispensing in the soldering step. Therefore, when there is a large number of electronic components 27, dispensing takes time and adds to the manufacturing time, which may increase the manufacturing cost of the light-emitting module 11.

Thus, manufacturing the light-emitting module 11 by sequentially performing the soldering step, the element mounting step, and the element sealing step as described above can reduce the manufacturing cost of the light-emitting module 11.

The elastic modulus of the sealing resin 53 is set to 15 MPa or lower at temperatures from minus 40 degrees to plus 150 degrees that is an expected range of practical use. As the elastic modulus of the sealing resin 53 is set to 15 MPa or lower, the load placed on the electrically conductive wires 50 disposed inside the frame 52 is small and thermal stress can be mitigated to reduce the occurrence of breakage etc. of the electrically conductive wires 50.

The viscosity of the sealing resin 53 is set to be equal to or lower than a certain value, for example, 15 Pa.s. As the viscosity of the sealing resin 53 is set to be equal to or lower than a certain value, air bubbles (voids) are less likely to form when the light-emitting elements 26 and the electrically conductive wires 50 disposed inside the frame 52 are sealed by the sealing resin 53, so that a stable luminous state of light radiated from the light-emitting elements 26 is achieved. Accordingly, the light-emitting elements 26 and the electrically conductive wires 50 can be sealed in a stable state while the amount of material used to form the sealing resin 53 is reduced to achieve a cost reduction.

On the other hand, the viscosity of the molding resin for forming the lens 54 is set to be higher than the viscosity of the sealing resin 53, and thus the fluidity of the molding resin is set to be lower than that of the sealing resin 53. As the viscosity of the molding resin is set to be higher than the viscosity of the sealing resin 53, the molding resin does not flow more than necessary when poured onto the sealing resin 53, so that the shape of the lens 54 is more likely to be formed in a desired shape.

Further, as the viscosity of the molding resin is set to be higher than the viscosity of the sealing resin 53, the light-emitting elements 26 and the electrically conductive wires 50 are sealed by low-viscosity sealing resin 53 while the light-emitting elements 26 are covered by the lens 54 molded with high accuracy. Thus, a favorable mounted state of the light-emitting elements 26 on the substrate 25 can be secured, as well as a favorable radiation state of light radiated from the light-emitting elements 26 toward the outside can be secured.

In the light source unit 8, the lands 34 and the electronic components 27 joined to the lands 34 are present closely around the frame 52. A clearance H1 between the frame 52 and the lands 34 positioned close to the frame 52 or a clearance H2 between the frame 52 and the electronic components 27 positioned close to the frame 52, whichever is smaller, is set to be 0.1 mm or larger (see FIG. 6).

In the light source unit 8, to achieve a manufacturing cost reduction etc., the frame 52 is formed as a resin material having fluidity is solidified as described above. Depending on the state of flow of the resin material having fluidity during formation of the frame 52, the resin material may come close to the lands 34 or the electronic components 27 positioned in the periphery.

In the light source unit 8, however, as described above, the clearance H1 between the frame 52 and the lands 34 or the clearance H2 between the frame 52 and the electronic components 27, whichever is smaller, is set to be 0.1 mm or larger. Generally, when forming the light-emitting module 11, a dimensional tolerance for the position of formation of the land 34 relative to the substrate 25 and a dimensional tolerance for the position of mounting of the electronic components 27 on the lands 34 are 0.1 mm.

Therefore, even when the resin material for forming the frame 52 flows, the resin material reaches none of the lands 34 and the electronic components 27, nor does the resin material for forming the frame 52 stick to the lands 34 and the electronic components 27 due to surface tension, so that the shape of the frame 52 formed upon hardening of the resin material is unlikely to become an inappropriate shape.

Thus, it is unlikely that the sealing resin 53 packed inside the frame 52 may leak from the frame 52 to the outside or that the height of the sealing resin 53 may become insufficient. The electronic components 27 and the electrically conductive wires 50 are entirely sealed by the sealing resin 53, and an appropriate light distribution state of light radiated from the light-emitting elements 26 can be secured.

Since the shape of the frame 52 is formed in an appropriate stable shape, the productivity of the light source unit 8 can be increased.

While in the light source unit 8, the clearance H1 between the frame 52 and the lands 34 or the clearance H2 between the frame 52 and the electronic components 27, whichever is smaller, is set to be 0.1 mm or larger, this clearance is more desirably set to be 0.2 mm or larger and even more desirably set to be 0.3 mm or larger.

A height T of the frame 52 from the substrate 25 is set to be not smaller than 0.5 times and not larger than 2.5 times a width W in a radial direction (see FIG. 7).

Thus, the area of the substrate 25 occupied by the frame 52 when the frame 52 is formed on the substrate 25 can be minimized, and a reduction in size and manufacturing cost of the light source unit 8 can be achieved. Further, a stable balance is secured between the width W for maintaining the strength of the frame 52 and the height H for determining the packing amount of the sealing resin 53 packed inside the frame 52. Accordingly, a stable state of packing of the sealing resin 53 inside the frame 52 can be secured, as well as a sufficient amount of packing of the sealing resin 53 for sealing the electronic components 27 and the electrically conductive wires 50 can be secured to thereby increase the reliability of the sealed state.

A process such as metal vapor deposition may be performed on a surface of the frame 52, or the frame 52 may be formed by a white resin. When the frame 52 has such a configuration, the frame 52 can function as a reflector that reflects part of light radiated from the light-emitting elements 26.

Thus, the frame 52 has both the function of determining the shapes of the sealing resin 53 and the lens 54 and the function of reflecting light, so that the functionality of the light source unit 8 can be enhanced without an increase in the number of parts.

In the light source unit 8 configured as described above, an annular gasket 55 is mounted by being fitted around the protruding part 15 of the socket housing 9 (see FIG. 4). The gasket 55 is formed by a resin material or a rubber material. In a state where the gasket 55 is mounted, the protruding part 15 of the light source unit 8 is inserted into the unit mounting part 6 of the lamp body 2 from the front side and rotated in the circumferential direction such that the engaging portions 20 are respectively engaged with the engaging protrusions 7 from the rear side (see FIG. 1). Here, the engaging protrusions 7 are held between the engaging portions 20 and the gasket 55, and the light source unit 8 is mounted to the lamp body 2. In the state where the light source unit 8 is mounted on the lamp body 2, the unit mounting part 6 is closed by the gasket 55, so that foreign matter, such as moisture, is prevented from entering the lamp chamber 5 through the unit mounting part 6.

Conversely, when the light source unit 8 is rotated in the circumferential direction opposite from the aforementioned direction, the engaging portions 20 are disengaged from the engaging protrusions 7, and the light source unit 8 can be removed from the lamp body 2 by pulling out the protruding part 15 from the unit mounting part 6.

In the state where the light source unit 8 is mounted on the lamp body 2, when a current is supplied from the power source circuit to the wiring pattern 33 through the connection terminals 22, light is radiated from at least one light-emitting element 26. Here, in the case where the vehicle lamp 1 functions as a tail lamp, light is radiated from the one light-emitting element 26 disposed at the center, and in the case where the vehicle lamp 1 functions as a stop lamp, light is radiated from the four light-emitting elements 26 other than the one disposed at the center. A configuration may be adopted in which light is radiated from the five light-emitting elements 26 in the case where the vehicle lamp 1 functions as a stop lamp.

Light radiated from the light-emitting elements 26 is transmitted through the sealing resin 53 and the lens 54 and emitted toward the outside through the cover 3. Here, the light emission direction is controlled by the lens 54, and the light is emitted toward the outside in a predetermined direction.

When light is radiated from the light-emitting elements 26, heat is generated in the light-emitting module 11. The generated heat is transferred to the first heat radiation part 13a through the adhesive 51 having excellent heat conductivity and thus transferred to the heat radiation plate 13 and the resin-molded part 12. The heat having been transferred to the heat radiation plate 13 and the resin-molded part 12 is released to the outside mainly from the first heat radiation fins 16 and the second heat radiation fins 17.

Thus, a favorable drive state of the lighting circuit is secured and a favorable light emission state of the light-emitting elements 26 is secured.

### Structure of Light Source Unit According to Second Embodiment

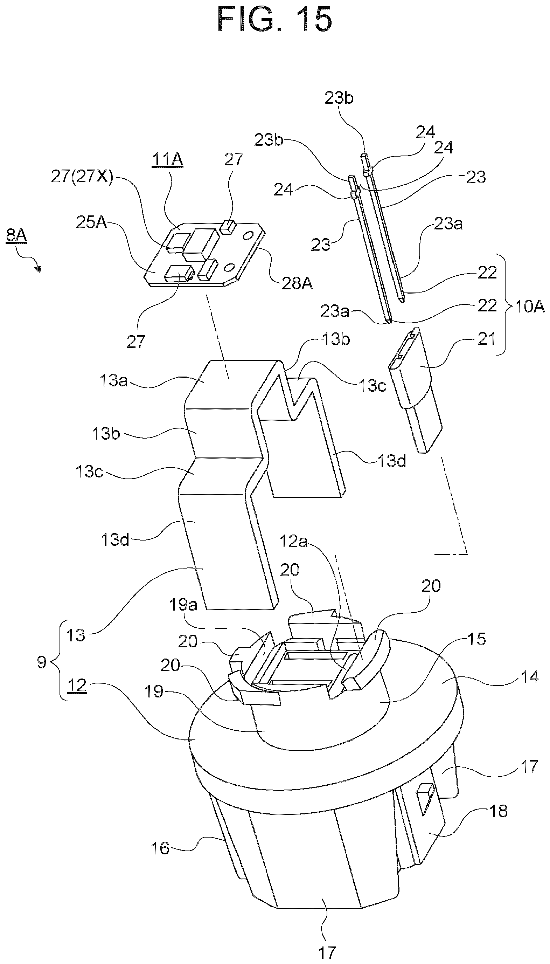

Next, the structure of a light source unit 8A according to a second embodiment will be described (see FIG. 15 through FIG. 25).

Compared with the light source unit 8 described above, the light source unit 8A shown below differs only in that the configuration of the light source module is different and the number of connection terminals is different. Therefore, only different parts from the light source unit 8 will be described in detail, while the other parts will be denoted by the same reference signs as those denoting the same parts in the light source unit 8 and description thereof will be omitted.

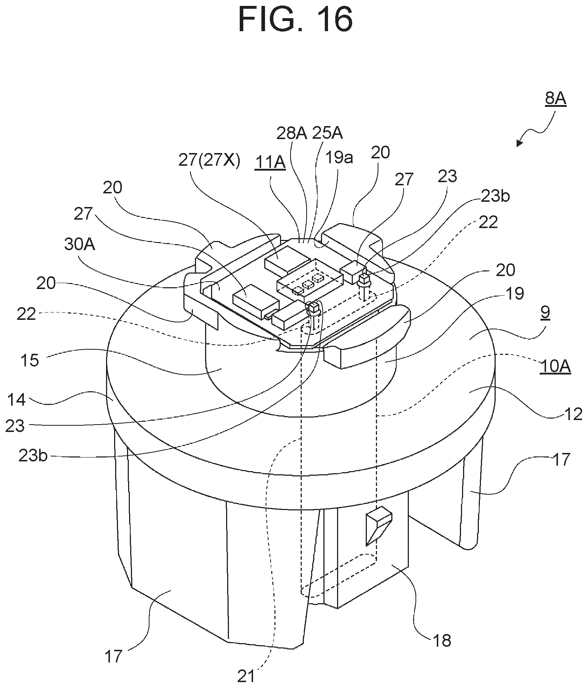

The light source unit 8A has the socket housing 9, a power feeder 10A, and a light-emitting module 11A (see FIG. 15 and FIG. 16).

The power feeder 10A has the terminal holding part 21 and the connection terminals 22. Of the connection terminals 22, one is provided as the ground terminal 22G for grounding and the other is provided for power supply. The connection terminal 22 for power supply is used for a fog lamp.

The light-emitting module 11A has a substrate 25A that has a substantially rectangular shape and faces the front-rear direction, a light-emitting body 60 mounted on the substrate 25A, and the various electronic components 27 mounted on the substrate 25A (see FIG. 15 through FIG. 17).

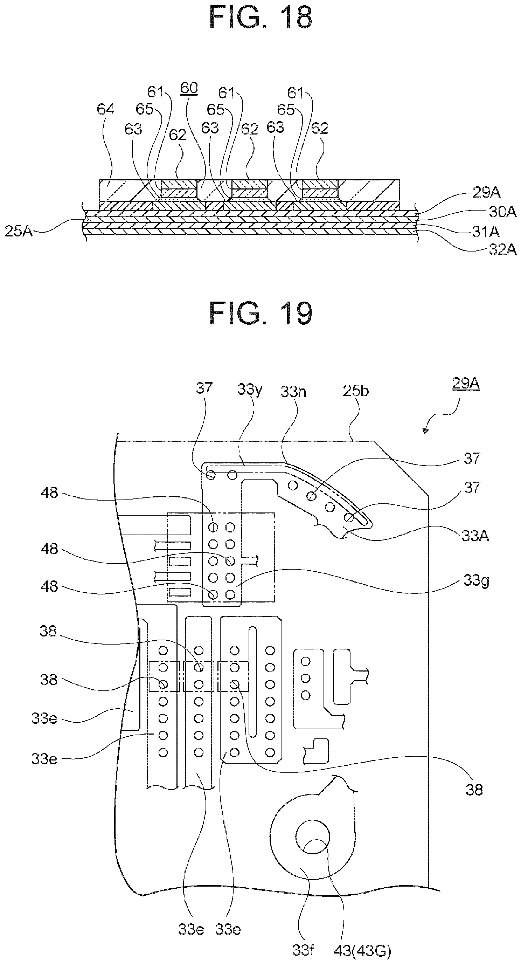

The light-emitting body 60 is provided as a package type in which, for example, three light-emitting elements 61, fluorescent bodies 62, and die pads 63 are sealed by a sealing part 64 (see FIG. 18).

The light-emitting elements 61 are positioned in a row at regular intervals in the left-right direction, for example, and light-emitting diodes (LEDs) are used as the light-emitting elements 61. The light-emitting elements 61 function as light sources for a fog lamp.

An interval between the light-emitting elements 61 is set to be small, for example, 0.5 mm or smaller. Thus, in a state where light is radiated from the light-emitting elements 61, a light distribution formed is less likely to be uneven in luminance and a desired light distribution can be easily formed. Since the interval between the light-emitting elements 61 is small, the size of the light-emitting body 60 is reduced accordingly, so that a reduction in size of the light source unit 8A can be achieved.

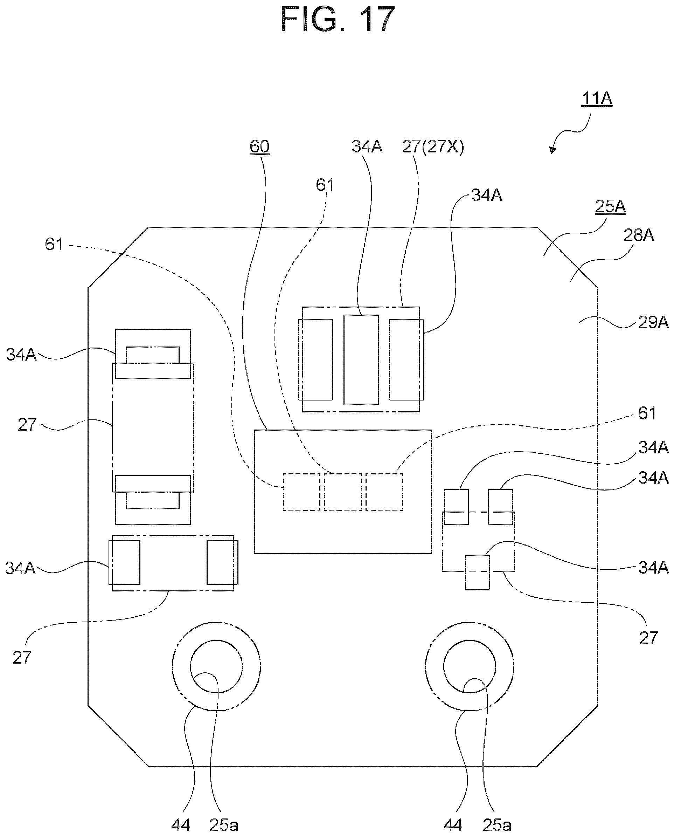

Each light-emitting element 61 has a square shape, for example, with a width P of one side set to be 1.4 mm or smaller (see FIG. 17). An overall width Q of the three light-emitting elements 61 in the array direction in which the light-emitting elements 61 are arrayed is set to be 4.0 mm or smaller.

Thus, in the light-emitting body 60, both the width P and the width Q of the light-emitting elements 61 functioning as light sources are set to be small, so that light is recognized as if radiated from a point light source as a whole. Therefore, the light distribution pattern has sharp cut lines, and an appropriate and clear light distribution pattern can be formed.

The number, array direction, and functions of the light-emitting elements 61 mounted on the substrate 25A can be set arbitrarily according to the type of the vehicle lamp 1, the required luminance, etc.

Each fluorescent body 62 is disposed in a state of covering the light-emitting element 61 from the front side, and functions to convert the color of light radiated from the light-emitting element 61.

Each die pad 63 is disposed on the opposite side of the light-emitting element 61 from the fluorescent body 62, and the light-emitting element 61 is joined to the die pad 63 by solder or a bonding agent (adhesive) 65 (see FIG. 18). The outer shape of the die pad 63 is set to be slightly larger than the outer shape of the light-emitting element 61. The die pad 63 is joined to a wiring pattern, to be described later, by soldering.

The sealing part 64 is formed by, for example, an opaque resin material.

The light-emitting body 60 has a flat rectangular parallelepiped shape, for example, and has front surfaces of the fluorescent bodies 62 exposed toward the front side and rear surfaces of the die pads 63 exposed toward the rear side. As the rear surfaces of the die pads 63 are exposed toward the rear side, it is easy to solder the die pads 63 to the wiring pattern, and the light-emitting body 60 can be easily and correctly mounted to the substrate 25A.

When lines in the light-emitting body 60 that pass through the centers of the respective light-emitting elements 61 and extend in the array direction of the light-emitting elements 61 are each called a central line V, in a state where the light source unit 8A is mounted on the lamp body 2, the central line V of the light-emitting body 60 has an inclination angle of five degrees or smaller upward and downward from a horizontal line.

When the central line V thus has an inclination angle of five degrees or smaller from the horizontal line, the light distribution pattern formed by light radiated from the light-emitting elements 61, particularly the light distribution pattern in a fog lamp becomes sharp, and an appropriate and clear light distribution pattern can be formed.

It is desirable that in the light source unit 8A, the light-emitting elements 61 be lighted by constant-current driving. When the light-emitting elements 61 are lighted by constant-current driving, a constant amount of current flows to the light-emitting elements 61, so that the amount of heat generated from the light-emitting elements 61 is less likely to fluctuate. Thus, there is no need to secure heat radiation performance according to fluctuations in the amount of heat generation in the light source unit 8A, and also in the case where the base plate 28 of the substrate 25A is formed by a resin material, a stable drive state of the light-emitting elements 61 can be secured.

The substrate 25A is formed as a wiring pattern, a heat radiation pattern, etc. are formed on a base plate 28A that is formed by a resin material, such as glass epoxy, and terminal insertion holes 25a are formed at a lower end part of the substrate 25A so as to be spaced apart in the left-right direction.

The substrate 25A is formed by, for example, the four layers of a first wiring layer 29A, a ground layer 30A, a second wiring layer 31A, and a heat radiation layer 32A that are laminated in this order from the front side in the thickness direction.

A wiring pattern 33A is formed in a front surface of the first wiring layer 29A (see FIG. 19). Lands 34A to which the electronic components 27 etc. are joined by solder 49 are formed at predetermined positions in the wiring pattern 33A (see FIG. 17). In the front surface of the first wiring layer 29A, an insulating resist (not shown) for protecting the wiring pattern 33A is applied to a part where the lands 34A are not formed.

The wiring pattern 33A has element connecting parts 33e to which the light-emitting elements 61 are respectively connected, first connecting parts 33f to which the connection terminals 22 are respectively connected, and a circuit connecting part 33g to which the integrated circuit 27X is connected (see FIG. 19). The element connecting parts 33e are formed at a center part of the substrate 25A, and the first connecting parts 33f and the circuit connecting part 33g are formed on substantially opposite sides from each other across the element connecting parts 33e.

A ground part 33h is formed in the wiring pattern 33A at a part that continues to the circuit connecting part 33g. The ground part 33h is formed at an outer circumferential part of the substrate 25A, and is positioned between the outer circumference 25b of the substrate 25A and the integrated circuit 27X mounted on the circuit connecting part 33g. The ground part 33h has a shape extending in the circumferential direction along the outer circumference 25b of the substrate 25A. As long as the ground part 33h is positioned between the outer circumference 25b of the substrate 25A and the integrated circuit 27X, the ground part 33h need not be formed so as to continue to the circuit connecting part 33g.

In the front surface of the first wiring layer 29A, a resist for protecting the wiring pattern 33A is applied to a predetermined part, while a resistless region 33y to which no resist has been applied is formed at a portion of the ground part 33h. For example, the resistless region 33y is formed in a substantially arc shape so as to conform to the outer circumference 25b of the substrate 25A according to the shape of the ground part 33h.

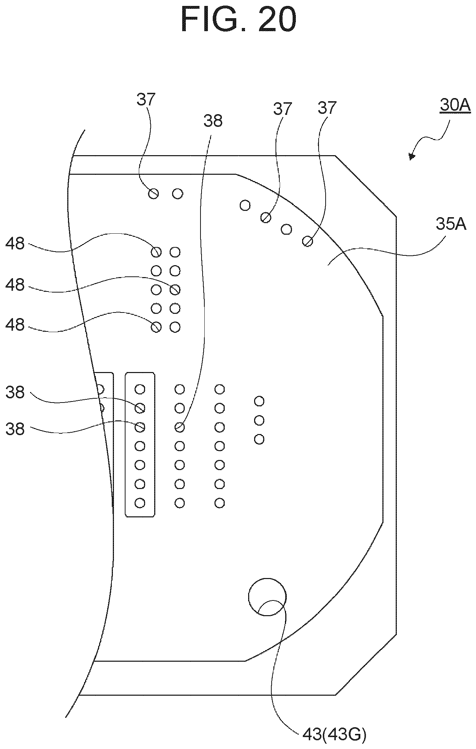

A ground pattern 35A is formed in a front surface or a rear surface of the ground layer 30A (see FIG. 20). The ground pattern 35A is formed in an area of half or more of the front surface or the rear surface of the ground layer 30A, and the ground pattern 35A is a part that is a so-called solid ground.

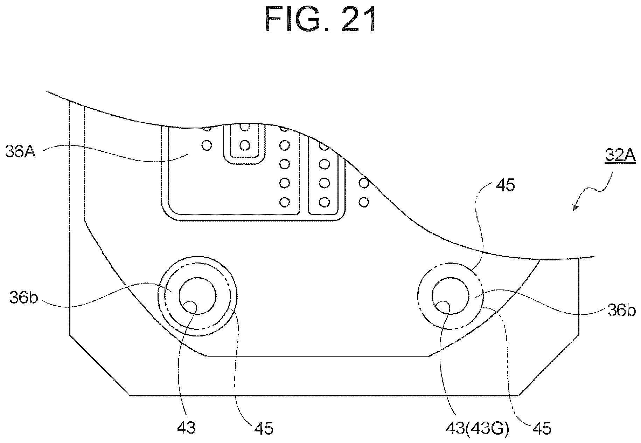

A wiring pattern (not shown) is formed in a front surface or a rear surface of the second wiring layer 31A, and a heat radiation pattern 36A is formed in the rear surface of the heat radiation layer 32A (see FIG. 21). In FIG. 21, the heat radiation pattern 36A etc. are shown in a transparent view in a state as seen from the front side. Second connecting parts 36b to which the connection terminals 22 are respectively connected are formed in the rear surface of the heat radiation layer 32A.

The ground part 33h of the wiring pattern 33A is connected to the ground pattern 35A of the ground layer 30A by the ground through-holes 37 (see FIG. 19 and FIG. 20).

As will be described later, the light source unit 8A is mounted to the lamp body 2 as the engaging portions 20 of the socket housing 9 are engaged with the engaging protrusions 7 of the lamp outer casing 4. In some cases, the light source unit 8A is mounted to a reflector (not shown).

Thus, the light source unit 8A is mounted to the lamp body 2 or the reflector. A part on which metal vapor deposition has been performed, for example, the reflective surface 2b is formed in the lamp body 2 and the reflector, and static electrical charges may jump into the integrated circuit 27X from the lamp body 2 or the reflector present on the outer circumferential side of the light source unit 8A, thereby disrupting the appropriate drive state of the circuit (lighting circuit) formed in the substrate 25A. In this case, to prevent static electrical charges from jumping in, it is conceivable to adopt a configuration in which the lamp body 2 or the reflector is connected to the ground, but adopting this configuration would increase the cost.

In the light source unit 8A, therefore, as described above, the ground part 33h is formed as a part of the wiring pattern 33A between the outer circumference 25b of the substrate 25A and the integrated circuit 27X. As the ground part 33h is formed, static electrical charges applied from the outer circumferential side of the substrate 25A are more likely to jump into the ground part 33h formed between the outer circumference 25b of the substrate 25A and the integrated circuit 27X, so that an appropriate drive state of the circuit formed in the substrate 25A can be secured without an increase in the manufacturing cost.

Since the ground part 33h is formed at an outer circumferential part of the substrate 25A, the ground part 33h can be formed in a shape conforming to the outer circumference 25b of the substrate 25A. Thus, the area of formation of the ground part 33h can be increased, as well as the ground part 33h can be formed at a position where the integrated circuit 27X is covered from the outer side, which can effectively prevent static electrical charges from jumping into the integrated circuit 27X.

Further, the resistless region 33y to which no resist has been applied is formed in the ground part 33h.

Thus, static electrical charges applied from the outer circumferential side of the substrate 25A are more likely to jump into the ground part 33h from the resistless region 33y, while the other portion of the ground part 33h than the resistless region 33y is protected by the resist, so that static electrical charges can be prevented from jumping into the integrated circuit 27X while the ground part 33h is protected.

Furthermore, the ground through-holes 37 connected to the ground part 33h are formed in the substrate 25A, and the ground part 33h is connected to the ground pattern 35A through the ground through-holes 37.

Thus, static electrical charges having jumped into the ground part 33h from the outer circumferential side of the substrate 25A flow through the ground through-holes 37 to the ground pattern 35A having a large area, which can more reliably prevent static electrical charges from jumping into the integrated circuit 27X.

While the example in which static electrical charges are prevented from jumping into the integrated circuit 27X has been shown above, the target for which static electrical charges are prevented from jumping in is not limited to the integrated circuit 27X, and the target may be another electronic component 27, such as a MOSFET, a diode, a capacitor, or a resistor.

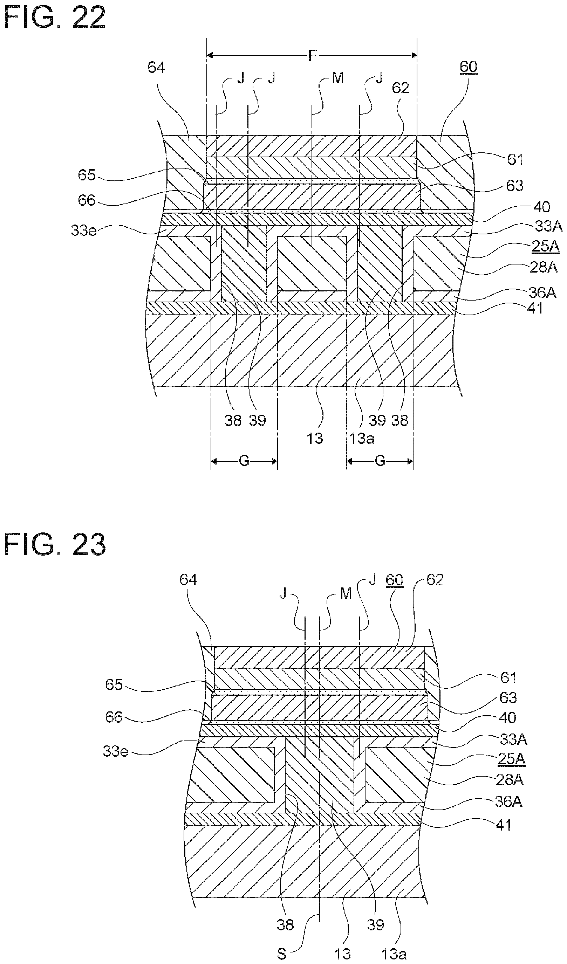

The element thermal vias 38 connected to the element connecting parts 33e are formed in the substrate 25A (see FIG. 19). Each element thermal via 38 has one end connected to the element connecting part 33e and the other end connected to the heat radiation pattern 36A (see FIG. 22). One or more element thermal vias 38 are formed for one element connecting part 33e and, for example, two element thermal vias 38 are positioned directly behind the light-emitting element 61.

In the light source unit 8A, heat resulting from driving the light-emitting elements 61 is transferred from the heat radiation pattern 36A to the heat radiation plate 13 through the wiring pattern 33A and the element thermal vias 38, and the element thermal vias 38 are positioned directly behind the light-emitting elements 61. Thus, the transfer path of the heat generated in the light-emitting elements 61 to the heat radiation pattern 36A is shortened and the resistance to heat conduction is reduced, so that high heat conductivity of the heat generated in the light-emitting elements 61 to the heat radiation plate 13 is secured.

In the light source unit 8A, at least part of the element thermal via 38 is present on an axis parallel to the central axis M of the light-emitting element 61, i.e., one of a reference axis J of reference axes J passing through the light-emitting element 61 and extending in the thickness direction of the substrate 25A (see FIG. 22 and FIG. 23).

Thus, in the light source unit 8A, at least part of the range of the element thermal via 38 indicated by G in FIG. 22 should be present in the range of the light-emitting element 61 indicated by F in FIG. 22.

In the light source unit 8A, one thermal via 38 may be present directly behind the light-emitting element 61. In this case, the central axis M passing through the center of the light-emitting element 61 and extending in the thickness direction of the substrate 25A and the centerline S of the thermal via 38 may coincide with each other (see FIG. 23). However, at least part of the thermal via 38 may be present on the central axis M of the light-emitting element 61, and the centerline S of the thermal via 38 may be offset from the central axis M of the light-emitting element 61 in a direction orthogonal to the thickness direction of the substrate 25A.

In a state where one or more thermal vias 38 are present directly behind the light-emitting element 61, at least part of the element thermal via 38 may be present on the central axis M.

In the light source unit 8A, it is desirable that one or more thermal vias 38 be entirely or substantially entirely positioned in a projected space P formed by projecting the light-emitting element 61 in an axial direction of the central axis M (see FIG. 22 and FIG. 23).

The resin (resin ink) 39 may be packed inside the element thermal via 38. Metal particles may be dispersed in the resin 39, and in this case, the resin 39 has high heat conductivity. In the case where the resin 39 is packed inside the element thermal via 38, a metal coating (cover plating) 40 is applied to the element connecting part 33e and a metal coating (cover plating) 41 is also applied to the heat radiation pattern 36A. The metal coating 40 may be formed as a land 34A, and the metal coating 41 may be formed as a thermal land.

The light-emitting element 61 is mounted on the first wiring layer 29A of the substrate 25A through the die pad 63 by solder 66, and as the metal coating 40 is present, the light-emitting element 61 is joined to the metal coating 40 at the element connecting part 33e. Thus, the light-emitting element 61 is joined to the metal coating 40, and not to the resin 39, by the solder 66, so that the light-emitting element 61 is bonded to the metal (metal coating 40) by the solder 66 and a high degree of bonding of the light-emitting element 61 to the substrate 25A can be secured.

In the substrate 25A, the light-emitting elements 61 are mounted on the wiring pattern 33A and the heat radiation pattern 36A is bonded to the first heat radiation part 13a of the heat radiation plate 13 by the heat-conducting adhesive 51. As the metal coating 40 and the metal coating 41 are applied, the resin 39 can be prevented from leaking out of the element thermal vias 38, as well as a high degree of connection of the light-emitting elements 61 to the wiring pattern 33A and a high degree of connection of the substrate 25A to the heat radiation plate 13 can be secured.

A resist (not shown) is applied to a part of the heat radiation pattern 36A to which the other ends of the element thermal vias 38 are connected, and the heat radiation pattern 36A is joined to the heat radiation plate 13 through the resist. Specifically, the resist is applied onto the metal coating 41.

Thus, the heat radiation pattern 36A is connected to the heat radiation plate 13 through the resist, and the heat radiation pattern 36A is bonded to the heat radiation plate 13 by the heat-conducting adhesive, so that favorable insulation between the heat radiation pattern 36A and the heat radiation plate 13 can be secured, as well as favorable heat conductivity from the light-emitting elements 61 to the heat radiation plate 13 through the heat radiation pattern 36A can be secured.

In the light source unit as described above, the light-emitting elements, the electronic components, etc. are mounted on the substrate, and heat is generated in the light-emitting elements, the electronic components, etc. when the light-emitting elements are driven. As the drive state of the light-emitting elements etc. may become unstable due to the generated heat, it is desirable to increase the degree of heat radiation to the outside (external space).

In particular, a lighting circuit of light-emitting elements formed in a substrate often incorporates a linear-regulator constant-current circuit in consideration of a cost reduction etc. In the case of a linear-regulator constant-current circuit, as a large amount of electricity is consumed in the linear regulator formed in an integrated circuit (IC), the amount of heat generated in the integrated circuit is likely to increase.

Meanwhile, some light source units use, as the substrate, a ceramic substrate having a high heat radiation property to increase the degree of heat radiation. When a ceramic substrate is used as the substrate, a favorable degree of heat radiation can be secured, but on the flip side, as the ceramic substrate is expensive, the manufacturing cost of the light source unit increases significantly.

Light source units are also required to secure an appropriate drive state of the circuit (lighting circuit) formed in the substrate by reducing the influence of electromagnetic noise. In particular, also in a linear-regulator constant-current circuit, it is desirable to reduce the influence of electromagnetic noise on the integrated circuit to thereby prevent malfunction of the circuit and secure an appropriate drive state.

In the light source unit 8A, therefore, as described above, the element thermal vias 38 each of which has one end and the other end respectively connected to the wiring pattern 33A and the heat radiation pattern 36A and transfers heat to the heat radiation plate 13 are formed in the substrate 25A of which the base plate 28A is formed by a resin material, and at least part of the element thermal via 38 is present on one of the reference axes J.

Thus, as the base plate 28A is formed by a resin material, the substrate 25A can be inexpensively formed. Since the light-emitting elements 61 and the element thermal vias 38 are positioned close to each other and the transfer path of heat resulting from driving the light-emitting elements 61 toward the element thermal vias 38 is shortened, a high degree of heat radiation can be secured while the manufacturing cost is reduced.

As a result, the drive state of the light-emitting elements 61 does not become unstable due to heat resulting from driving the light-emitting elements 61, and a favorable luminous state of the light-emitting elements 61 can be secured.

The light source unit 8A can also have a configuration in which at least part of the element thermal via 38 is present on the central axis M.

In this case, the element thermal via 38 is present at a position closer to the center of the light-emitting element 61, so that the transfer path of heat resulting from driving the light-emitting element 61 toward the element thermal via 38 is further shortened and the degree of heat radiation can be further increased.

In particular, when a configuration in which the central axis M of the light-emitting element 61 and the centerline S of the element thermal via 38 coincide with each other is adopted, the center of the element thermal via 38 is present at a position closer to the center of the light-emitting element 61. Thus, the transfer path of heat resulting from driving the light-emitting element 61 toward the element thermal via 38 is even further shortened and the degree of heat radiation can be even further increased.

When the element thermal via 38 is entirely positioned in the projected space P formed by projecting the light-emitting element 61 in the axial direction of the central axis M, the element thermal via 38 is not present on the outer side of the projected space P. Thus, the transfer path of heat resulting from driving the light-emitting element 61 toward the element thermal via 38 is shortened and the degree of heat radiation can be further increased.

Further, when the two element thermal vias 38 are entirely positioned in the projected space P, an extremely high degree of heat radiation can be secured.

Furthermore, in the light source unit 8A, in the package-type light-emitting body 60 in which the plurality of light-emitting elements 61 is respectively joined to the die pads 63 and the plurality of light-emitting elements 61 is sealed by the sealing part 64, at least part of the element thermal via 38 is present on one of the reference axes J of each of the plurality of light-emitting elements 61.

Thus, as the package-type light-emitting body 60 is mounted on the substrate 25A, there is no need to separately mount the plurality of light-emitting elements 61 onto the substrate 25A and an appropriate distance between the plurality of light-emitting elements 61 is secured, as well as the work of mounting the light-emitting elements 61 onto the substrate 25A is made easy. As a result, an appropriate light distribution pattern can be secured as well as the work efficiency can be increased, while the degree of heat radiation relating to the plurality of light-emitting elements 61 is increased.

In addition, the plurality of electronic components 27 is each connected to the wiring pattern 33A by the solder 49, and the plurality of die pads 63 in the light-emitting body 60 is each connected to the wiring pattern 33A by the solder 66.

Thus, as the plurality of electronic components 27 and the plurality of light-emitting elements 61 are each connected to the wiring pattern 33A by soldering, the plurality of electronic components 27 and the plurality of light-emitting elements 61 can be collectively mounted by soldering, which can increase the productivity of the light source unit 8A.

The terminal through-holes 43 that are respectively connected to the first connecting parts 33f are formed in the substrate 25A (see FIG. 19, FIG. 24, and FIG. 25). Each terminal through-hole 43 has one end connected to the first connecting part 33f and the other end connected to the second connecting part 36b.

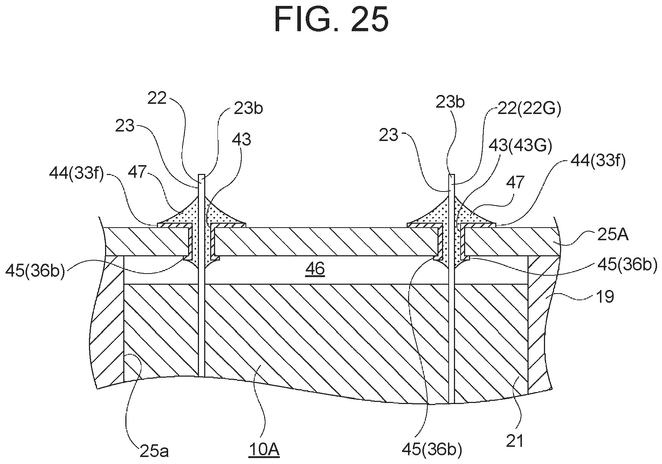

In the first wiring layer 29A of the substrate 25A, the first terminal lands 44 of an annular shape, for example, are formed on the first connecting parts 33f (see FIG. 17, FIG. 24, and FIG. 25). In the heat radiation layer 32A of the substrate 25A, the second terminal lands 45 of an annular shape, for example, are formed on the second connecting part 36b (see FIG. 21 and FIG. 25). The outer shape of the second terminal land 45 is set to be smaller than the outer shape of the first terminal land 44.

The connection terminals 22 of the power feeder 10A are respectively inserted into the terminal through-holes 43 from the side of the second connecting parts 36b, and the connection terminals 22 are connected to the substrate 25A by being joined to the first terminal lands 44, the terminal through-holes 43, and the second terminal lands 45. In the state where the connection terminals 22 are connected to the substrate 25A, the terminal holding part 21 is held by the socket housing 9 in a state of being inserted in the inserting-placing hole 12a, and the substrate 25A and the terminal holding part 21 are spaced apart in the front-rear direction such that the space 46 is formed therebetween (see FIG. 25). In the space 46, the second terminal lands 45 are positioned.

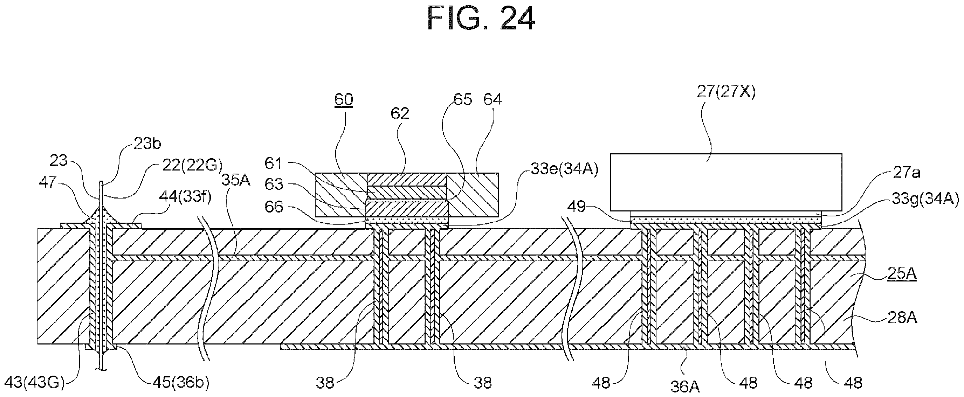

The ground pattern 35A formed in the ground layer 30A is connected to the ground terminal through-hole 43G (see FIG. 24).

Also in the light source unit 8A, as in the light source unit 8, the outer shape of the second terminal land 45 is set to be smaller than the outer shape of the first terminal land 44, so that the amount of solder 47 for the second terminal land 45 becomes smaller than the amount of solder 47 for the first terminal land 44. Thus, the solder 47 is less likely to flow to the terminal holding part 21 of the power feeder 10A, as well as is less likely to flow toward the second terminal lands 45 where the adjacent connection terminals 22 are joined.

In the light source unit as described above, the power feeder for applying a current to the light-emitting elements is provided, and the power feeder has the terminal holding part formed by an insulating resin material and the connection terminals held by the terminal holding part.

The connection terminals of the power feeder are joined by solder to the terminal lands formed on the wiring pattern in the state of being inserted in the terminal through-holes formed in the substrate.

Thus, electricity is supplied from the power source circuit to the light-emitting elements through the connection terminals of the power feeder and the wiring pattern.

As the connection terminals are joined in the state of being inserted in the terminal through-holes by solder that flows from the terminal lands to the terminal through-holes, the solder may flow through the terminal through-holes toward the terminal holding part before hardening, and when the amount of flow is large, the solder may reach the terminal holding part.

If the solder thus reaches the terminal holding part, the terminal holding part formed by an insulating resin material may be melted by the solder, so that the strength of the power feeder may decrease or the connection terminals may fall off the terminal holding part.

In the case where the power feeder has a plurality of connection terminals, for example, a connection terminal for power supply and a connection terminal for grounding, provided in a row, when the amount of solder flowing through the terminal through-holes to the terminal holding part is large, the solder may flow from the side of one connection terminal to the side of the other connection terminal, and in this case, the insulation between the connection terminals may be disrupted and short-circuit may occur.

In the light source unit 8A, as described above, the terminal through-hole 43 into which a portion of the connection terminal 22 is inserted from the side of the second connecting part 36b is formed in the substrate 25A between the first connecting part 33f and the second connecting part 36b. The size of the second terminal land 45 is set to be smaller than the size of the first terminal land 44, and a portion of the connection terminal 22 is joined to the terminal through-hole 43, the first terminal land 44, and the second terminal land 45 by the solder 47.

Thus, the amount of solder 47 applied to the second terminal land 45 becomes smaller than the amount of solder applied to the first terminal land 44, and the amount of solder 47 flowing through the terminal through-hole 43 toward the terminal holding part 21 is reduced, so that the solder 47 can be prevented from reaching the terminal holding part 21 and favorable functionality of the power feeder 10A can be secured.

In particular, the terminal holding part 21 formed by an insulating resin material can be prevented from being melted by the solder 47, so that a decrease in strength of the power feeder 10A and falling of the connection terminals 22 off the terminal holding part 21 can be prevented.

Moreover, since the amount of solder 47 flowing through the terminal through-hole 43 toward the terminal holding part 21 is reduced, the solder 47 is less likely to flow also toward the second terminal lands 45 where the adjacent connection terminals 22 are joined, so that insulation between the connection terminals 22 is secured and short-circuit can be prevented.

Further, the power feeder 10A has the terminal holding part 21 held in the state of being embedded in the socket housing 9.

Thus, a portion of the connection terminal 22 is connected to the substrate 25A in the state where the terminal holding part 21 is held by the socket housing 9, so that a stable state of connection of the power feeder 10A to the substrate 25A is secured, and a favorable state of current application to the light-emitting elements 61 through the connection terminals 22 and the wiring pattern 33A can be secured.

Furthermore, the socket housing 9 is provided with the resin-molded part 12 that is formed by a heat-conducting resin material, and the terminal holding part 21 is embedded in the resin-molded part 12.

Thus, heat generated in the light-emitting elements 61 and the substrate 25A is released to the outside by the resin-molded part 12 in which the terminal holding part 21 is embedded, so that high functionality of the socket housing 9 can be secured.

Furthermore, in the light source unit 8A, in the package-type light-emitting body 60 in which the plurality of light-emitting elements 61 is each joined to the die pad 63 and the plurality of light-emitting elements 61 is sealed by the sealing part 64, the plurality of light-emitting elements 61 is connected to the wiring pattern 33A.

Thus, as the package-type light-emitting body 60 is mounted on the substrate 25A, there is no need to separately mount the plurality of light-emitting elements 61 onto the substrate 25A and an appropriate distance between the plurality of light-emitting elements 61 is secured, as well as the work of mounting the light-emitting elements 61 onto the substrate 25A is made easy. As a result, the strength of the power feeder 10A can be enhanced as well as the connection terminals 22 can be prevented from falling off the terminal holding part 21, while an appropriate light distribution pattern is secured and work efficiency is increased.

In the substrate 25A, the circuit thermal vias 48 connected to the circuit connecting part 33g are formed in a row in the up-down and left-right directions, for example (see FIG. 19). Each circuit thermal via 48 has one end connected to the circuit connecting part 33g and the other end connected to the heat radiation pattern 36A (see FIG. 24).

At the circuit connecting part 33g, the integrated circuit 27X is connected onto the circuit thermal vias 48. The integrated circuit 27X has the heat radiation pad 27a connected to the circuit connecting part 33g by the solder 49.

In the light source unit 8A, heat resulting from driving the integrated circuit 27X is transferred from the heat radiation pattern 36A to the heat radiation plate 13 through the wiring pattern 33A and the circuit thermal vias 48. Since the circuit thermal vias 48 are positioned directly behind the integrated circuit 27X, the transfer path of the heat generated in the integrated circuit 27X to the heat radiation pattern 36A is shortened and the resistance to heat conduction is reduced, so that high heat conductivity of the heat generated the integrated circuit 27X to the heat radiation plate 13 is secured.

Also in the circuit thermal via 48, as in the case of the element thermal via 38, a resin (resin ink) may be packed inside and metal particles may be dispersed in the resin. A metal coating (cover plating) may be applied to each of the circuit connecting part 33g and the heat radiation pattern 36A.

The circuit thermal vias 48 are connected to the ground pattern 35A that is formed in an area of half or more of the ground layer 30A. As described above, the ground pattern 35A is connected to the ground terminal through-hole 43G among the terminal through-holes 43 into which the ground terminal 22G is inserted. Thus, the circuit thermal vias 48 are connected to the ground terminal 22G through the ground pattern 35A and the ground terminal through-hole 43G.

A resist (not shown) is applied to the part of the heat radiation pattern 36A to which the other ends of the circuit thermal vias 48 are connected, and the heat radiation pattern 36A is joined to the heat radiation plate 13 through the resist by a heat-conducting adhesive.

Thus, the heat radiation pattern 36A is connected to the heat radiation plate 13 through the resist, and the heat radiation pattern 36A is bonded to the heat radiation plate 13 by the heat-conducting adhesive, so that favorable insulation between the heat radiation pattern 36A and the heat radiation plate 13 can be secured, and favorable heat conductivity from the integrated circuit 27X to the heat radiation plate 13 through the heat radiation pattern 36A can be secured.

At the element connecting parts 33e of the substrate 25A, the light-emitting elements 61 are connected onto the element thermal vias 38. The light-emitting elements 61 have the die pads 63 connected to the element connecting parts 33e by the solder 66.

In the light source unit 8A, heat resulting from driving the light-emitting elements 61 is transferred from the heat radiation pattern 36A to the heat radiation plate 13 through the wiring pattern 33A and the element thermal vias 38. Since the element thermal vias 38 are positioned directly behind the light-emitting elements 61, the transfer path of the heat generated in the light-emitting elements 61 to the heat radiation pattern 36A is shortened and the resistance to heat conduction is reduced, so that high heat conductivity of the heat generated in the light-emitting elements 61 to the heat radiation plate 13 is secured.

The element thermal vias 38 are connected to the ground pattern 35A that is formed in an area of half or more of the ground layer 30A. As described above, the ground pattern 35A is connected to the ground terminal through-hole 43G into which the ground terminal 22G is inserted among the terminal through-holes 43. Thus, the element thermal vias 38 are connected to the ground terminal 22G through the ground pattern 35A and the ground terminal through-holes 43G.

A resist (not shown) is applied to the part of the heat radiation pattern 36A to which the other ends of the element thermal vias 38 are connected, and the heat radiation pattern 36A is joined to the heat radiation plate 13 through the resist by a heat-conducting adhesive.

Thus, the heat radiation pattern 36A is connected to the heat radiation plate 13 through the resist, and the heat radiation pattern 36A is bonded to the heat radiation plate 13 by the heat-conducting adhesive, so that favorable insulation between the heat radiation pattern 36A and the heat radiation plate 13 can be secured, as well as favorable heat conductivity from the light-emitting elements 61 to the heat radiation plate 13 through the heat radiation pattern 36A can be secured.

As described above, in the light source unit 8A, the substrate 25A of which the base plate 28A is formed by a resin material is composed of the plurality of layers including the ground layer 30A and laminated in the thickness direction. The ground pattern 35A is formed in an area of half or more of the ground layer 30A, and the circuit thermal vias 48 are connected to the ground pattern 35A and the ground pattern 35A is connected to the ground terminal 22G.

Thus, the circuit thermal vias 48 that transfer heat generated in the integrated circuit 27X to the heat radiation plate 13 are connected to the ground pattern 35A that is formed in an area of half or more of the ground layer 30A, and the ground pattern 35A is connected to the ground terminal 22G. Accordingly, as the base plate 28A is formed by a resin material, the substrate 25A can be inexpensively formed. As a result, a high degree of heat radiation of heat generated in the integrated circuit 27X can be secured while the manufacturing cost is reduced. Moreover, as the ground potential of the substrate 25A becomes a low impedance, the influence of static electrical charges on the integrated circuit 27X can be prevented to secure an appropriate drive state of the circuit formed in the substrate 25A.

In particular, also in the case where a linear-regulator constant-current circuit is incorporated, efficient heat radiation and an appropriate drive state of the lighting circuit can be secured.

The heat radiation pad 27a is provided on the bottom surface of the integrated circuit 27X, and the plurality of circuit thermal vias 48 is formed. The circuit connecting part 33g to which the heat radiation pad 27a is connected is formed in the wiring pattern 33A, and the plurality of circuit thermal vias 48 is connected to the circuit connecting part 33g.

Thus, as the plurality of circuit thermal vias 48 is connected to the heat radiation pad 27a of the integrated circuit 27X through the circuit connecting part 33g, the degree of heat radiation of heat generated in the integrated circuit 27X can be further increased.

Further, in the light source unit 8A, in the package-type light-emitting body 60 in which the plurality of light-emitting elements 61 is each joined to the die pad 63 and the plurality of light-emitting elements 61 is sealed by the sealing part 64, the plurality of element thermal vias 38 each of which has one end and the other end respectively connected to the wiring pattern 33A and the heat radiation pattern 36A and transfers heat generated in the light-emitting element 61 to the heat radiation plate 13 is formed in the substrate 25A. The element thermal vias 38 are connected to the ground pattern 35A, and the ground pattern 35A is connected to the ground terminal 22G.

Thus, as the package-type light-emitting body 60 is mounted on the substrate 25A, there is no need to separately mount the plurality of light-emitting elements 61 onto the substrate 25A and an appropriate distance between the plurality of light-emitting elements 61 is secured, as well as the work of mounting the light-emitting elements 61 onto the substrate 25A is made easy. As a result, the influence of electromagnetic noise and heat can be reduced to secure an appropriate drive state of the light-emitting elements 61, while an appropriate light distribution pattern is secured and work efficiency is increased.

Further, the plurality of element connecting parts 33e to which the plurality of die pads 63 is respectively connected is formed in the wiring pattern 33A, and the plurality of element thermal vias 38 is connected to the element connecting parts 33e.

Thus, the plurality of element thermal vias 38 is connected through the element connecting parts 33e to the die pads 63 to which the light-emitting elements 61 are joined, which can further increase the degree of heat radiation of heat generated in the light-emitting elements 61.

The substrate 25A has the rear surface bonded to the surface of the first heat radiation part 13a of the heat radiation plate 13 by the adhesive 51 having high heat conductivity.

In the following, an outline of the manufacturing process of the light-emitting module 11A will be described.

To manufacture the light-emitting module 11A, in a soldering step, a solder paste is applied by printing to the lands 34A formed on the substrate 25A. The electronic components 27 and the light-emitting body 60 are respectively mounted on the solder, and the electronic components 27 and the die pads 63 of the light-emitting body 60 are joined to the lands 34A by reflow.

In this way, the electronic components 27 and the light-emitting body 60 of the light-emitting module 11A can be collectively mounted to the substrate 25 by the soldering step, so that the manufacturing time can be shortened and the manufacturing cost can be reduced.

In the light source unit 8A configured as has been described above, the annular gasket 55 is mounted by being fitted around the protruding part 15 of the socket housing 9, and the light source unit 8A is attached to and detached from the lamp body 2 in the same manner as the light source unit 8.

In the state where the light source unit 8A is mounted on the lamp body 2, when a current is supplied from the power source circuit to the wiring pattern 33A through the connection terminals 22, light is radiated from the light-emitting elements 61.

The light radiated from the light-emitting elements 61 is converted in color by the fluorescent bodies 62 and emitted toward the outside through the cover 3.

When light is radiated from the light-emitting elements 61, heat is generated in the light-emitting module 11A, and the generated heat is transferred to the first heat radiation part 13a through the adhesive 51 having excellent heat conductivity and thus transferred to the heat radiation plate 13 and the resin-molded part 12. The heat having been transferred to the heat radiation plate 13 and the resin-molded part 12 is released to the outside mainly from the first heat radiation fins 16 and the second heat radiation fins 17.

Thus, a favorable drive state of the lighting circuit is secured, as well as a favorable luminous state of the light-emitting elements 61 is secured.

### REFERENCE SIGNS LIST

- 1: vehicle lamp
- 8: light source unit
- 9: socket housing
- 10: power feeder
- 11: light-emitting module
- 12: resin-molded part
- 13: heat radiation plate
- 20: engaging portion
- 21: terminal holding part
- 22: connection terminal
- 22G: ground terminal
- 25: substrate
- 26: light-emitting element
- 27: electronic component
- 27X: integrated circuit
- 27a: heat radiation pad
- 28: base plate
- 30: ground layer
- 33: wiring pattern
- 33a: element connecting part
- 33b: first connecting part
- 33c: circuit connecting part
- 33d: ground part
- 33x: resistless region
- 34: land
- 35: ground pattern
- 36: heat radiation pattern
- 36a: second connecting part
- 37: ground through-hole
- 38: element thermal via
- 43: terminal through-hole
- 43G: ground terminal through-hole
- 44: first terminal land
- 45: second terminal land
- 48: circuit thermal via
- 51: adhesive
- 52: frame
- 53: sealing resin
- 54: lens
- 8A: light source unit
- 10A: power feeder
- 11A: light-emitting module
- 25A: substrate
- 28A: base plate
- 30A: ground layer
- 33A: wiring pattern
- 33e: element connecting part
- 33f: first connecting part
- 33g: circuit connecting part
- 33h: ground part
- 33y: resistless region
- 34A: land
- 35A: ground pattern
- 36A: heat radiation pattern
- 36b: second connecting part
- 60: light-emitting body
- 61: light-emitting element
- 62: fluorescent body
- 63: die pad
- 64: sealing part
- 66: solder

## Claims

1. A light source unit comprising:
a socket housing having an engaging portion that is engaged with a predetermined member;
a substrate having a base plate formed by a resin material and a wiring pattern formed in at least a surface on one side, in a thickness direction, of the base plate;
a light-emitting element that is connected to the wiring pattern and functions as a light source;
a frame having an annular shape, the frame being formed on the substrate and covering the light-emitting element from a periphery;
a sealing resin that is packed inside the frame and seals the light-emitting element; and
an electronic component joined to a land that is formed on an outer circumferential side of the frame as a part of the wiring pattern,
wherein the frame is formed as a resin material having fluidity applied to the substrate is hardened, and
wherein a clearance between the frame and the land or a clearance between the frame and the electronic component, whichever is smaller, is set to be 0.1 mm or larger.

2. A light source unit comprising:
a socket housing having an engaging portion that is engaged with a predetermined member and a heat radiation plate that radiates heat to an outside;
a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate; and
a light-emitting element that is connected to the wiring pattern and functions as a light source,
wherein an element thermal via that has one end and the other end respectively connected to the wiring pattern and the heat radiation pattern and transfers heat to the heat radiation plate is formed in the substrate, and
wherein, when axes passing through the light-emitting element and extending in a thickness direction of the substrate are called reference axes, at least part of the element thermal via is present on one of the reference axes.

3. The light source unit according to claim 2, wherein, when one of the reference axes that passes through a center of the light-emitting element is called a central axis, at least part of the element thermal via is present on the central axis.

4. The light source unit according to claim 2 or claim 3, wherein the element thermal via is entirely positioned in a projected space obtained by projecting the light-emitting element in an axial direction of a reference axis of the reference axes.

5. The light source unit according to claim 2, claim 3, or claim 4, wherein:
a package-type light-emitting body is provided in which a plurality of the light-emitting elements is each joined to a die pad and at least the plurality of the light-emitting elements is sealed by a sealing part;
a plurality of the element thermal vias is formed in the substrate; and
at least part of the element thermal via is present on each of the reference axes of the plurality of the light-emitting elements.

6. The light source unit according to claim 5, wherein:
a plurality of electronic components is each connected to the wiring pattern by solder; and
a plurality of the die pads is each connected to the wiring pattern by solder.

7. The light source unit according to claim 2, claim 3, claim 4, claim 5, or claim 6, wherein:
a resist is applied to the heat radiation pattern; and
the heat radiation pattern is joined to the heat radiation plate through the resist by a heat-conducting adhesive.

8. A light source unit comprising:
a socket housing having an engaging portion that is engaged with a predetermined member and a heat radiation plate that radiates heat to an outside;
a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate;
a light-emitting element that is connected to the wiring pattern and functions as a light source;
a plurality of electronic components including an integrated circuit and connected to the wiring pattern; and
a plurality of connection terminals including a ground terminal and connected to a power source,
wherein a circuit thermal via that has one end and the other end respectively connected to the wiring pattern and the heat radiation pattern and transfers heat generated in the integrated circuit to the heat radiation plate is formed in the substrate,
wherein the substrate is formed by a plurality of layers including a ground layer and laminated in a thickness direction;
wherein a ground pattern is formed in an area of half or more of the ground layer; and
wherein the circuit thermal via is connected to the ground pattern and the ground pattern is connected to the ground terminal.

9. The light source unit according to claim 8, wherein:
a heat radiation pad is provided on a bottom surface of the integrated circuit;
a plurality of the circuit thermal vias is formed;
a circuit connecting part to which the heat radiation pad is connected is formed in the wiring pattern; and
the plurality of the circuit thermal vias is connected to the circuit connecting part.

10. The light source unit according to claim 8 or claim 9, wherein:
a package-type light-emitting body is provided in which a plurality of the light-emitting elements is each joined to a die pad and at least the plurality of the light-emitting elements is sealed by a sealing part;
a plurality of element thermal vias each of which has one end and the other end respectively connected to the wiring pattern and the heat radiation pattern and transfers heat generated in the light-emitting element to the heat radiation plate is formed in the substrate; and
the element thermal vias are connected to the ground pattern and the ground pattern is connected to the ground terminal.

11. The light source unit according to claim 10, wherein:
a plurality of element connecting parts to which a plurality of the die pads is respectively connected is formed in the wiring pattern; and
the plurality of element thermal vias is connected to the element connecting parts.

12. The light source unit according to claim 8, claim 9, claim 10, or claim 11, wherein:
a resist is applied to the heat radiation pattern; and
the heat radiation pattern is joined to the heat radiation plate through the resist by a heat-conducting adhesive.

13. A light source unit comprising:
a socket housing having an engaging portion that is engaged with a predetermined member and a heat radiation plate that radiates heat to an outside;
a substrate having a wiring pattern formed in at least a surface on one side in a thickness direction and a heat radiation pattern formed in a surface on the other side in the thickness direction, the heat radiation pattern being connected to the heat radiation plate;
a power feeder having a terminal holding part formed by an insulating resin material and a connection terminal held by the terminal holding part, both end portions of the connection terminal protruding from the terminal holding part; and
a light-emitting element that is connected to the wiring pattern and functions as a light source;
wherein a first connecting part and a second connecting part are formed in the substrate so as to be spaced apart in a thickness direction,
wherein a first terminal land is formed on the first connecting part, and a second terminal land is formed on the second connecting part,
wherein a terminal through-hole into which a portion of the connection terminal is inserted from a side of the second connecting part is formed in the substrate between the first connecting part and the second connecting part,
wherein a size of the second terminal land is set to be smaller than a size of the first terminal land, and
wherein a portion of the connection terminal is joined to the terminal through-hole, the first terminal land, and the second terminal land by solder.

14. The light source unit according to claim 13, wherein the power feeder has the terminal holding part held in a state of being embedded in the socket housing.

15. The light source unit according to claim 14, wherein:
the socket housing is provided with a resin-molded part formed by a heat-conducting resin material; and
the terminal holding part is embedded in the resin-molded part.

16. The light source unit according to claim 13, claim 14, or claim 15, wherein:
a package-type light-emitting body is provided in which a plurality of the light-emitting elements is each joined to a die pad and at least a plurality of the heat radiation plates and the plurality of the light-emitting elements are sealed by a sealing resin; and
the light-emitting elements of the light-emitting body are connected to the wiring pattern.

17. A light source unit comprising:
a socket housing having an engaging portion that is engaged with a predetermined member and a heat radiation plate that radiates heat to an outside;
a substrate having a base plate formed by a resin material, a wiring pattern formed in at least a surface on one side, in a thickness direction, of the base plate, and a heat radiation pattern formed in a surface on the other side, in the thickness direction, of the base plate, the heat radiation pattern being connected to the heat radiation plate;
a light-emitting element that is connected to the wiring pattern and functions as a light source; and
a plurality of electronic components including an integrated circuit and connected to the wiring pattern,
wherein a ground part is formed as a part of the wiring pattern between an outer circumference of the substrate and the integrated circuit.

18. The light source unit according to claim 17, wherein the ground part is formed at an outer circumferential part of the substrate.

19. The light source unit according to claim 17 or claim 18, wherein a resistless region to which no resist has been applied is formed in the ground part.

20. The light source unit according to claim 17, claim 18, or claim 19, wherein:
the substrate is formed by a plurality of layers including a ground layer and laminated in a thickness direction;
a ground pattern is formed in an area of half or more of the ground layer;
a ground through-hole connected to the ground part is formed in the substrate; and
the ground part is connected to the ground pattern through the ground through-hole.
